(19) 

Europäisches
Patentamt
European
Patent Office
Office européen
des brevets

(11) **EP 2 731 195 A1**

(12) **EUROPEAN PATENT APPLICATION**

(43) Date of publication:
**14.05.2014 Bulletin 2014/20**

(51) Int Cl.:
*H01Q 3/01* (2006.01)　　　*H01Q 13/08* (2006.01)

(21) Application number: **13189871.0**

(22) Date of filing: **23.10.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **12.11.2012 JP 2012248259
03.06.2013 JP 2013117390**

(71) Applicants:
• **NITTO DENKO CORPORATION
Ibaraki-shi, Osaka 567-8680 (JP)**
• **OSAKA UNIVERSITY
Suita-shi, Osaka 565-0871 (JP)**

(72) Inventors:
• **Inoue, Masami
Ibaraki-shi, Osaka 567-8680 (JP)**
• **Hodono, Masayuki
Ibaraki-shi, Osaka 567-8680 (JP)**
• **Honjo, Mitsuru
Ibaraki-shi, Osaka 567-8680 (JP)**
• **Nagatsuma, Tadao
Suita-shi, Osaka 565-0871 (JP)**
• **Fujita, Masayuki
Suita-shi, Osaka 565-0871 (JP)**

(74) Representative: **Gill, Stephen Charles
Mewburn Ellis LLP
33 Gutter Lane
London
EC2V 8AS (GB)**

(54) **Antenna module**

(57)　　A dielectric film has a main surface and a back surface and is formed of resin. Electrodes that can receive or transmit an electromagnetic wave having a frequency of not less than 0.05 THz and not more than 10 THz in the terahertz band are formed on the main surface of the dielectric film. The electrodes constitute a tapered slot antenna. The dielectric film and the electrodes are formed of a flexible printed circuit board. A semiconductor device that is operable at a frequency in the terahertz band is mounted on the main surface of the dielectric film so as to be electrically connected to the electrodes.

F I G. 1

**Description**

BACKGROUND OF THE INVENTION

Field of the Invention

The present invention relates to an antenna module that transmits or receives an electromagnetic wave of a frequency in a terahertz band not less than 0.05 THz and not more than 10 THz, for example.

Description of Related Art

Terahertz transmission using an electromagnetic wave in the terahertz band is expected to be applied to various purposes such as short-range super high speed communication and uncompressed delayless super high-definition video transmission.

A terahertz oscillation device using a semiconductor substrate is described in JP 2010-57161 A. In the terahertz oscillation device described in JP 2010-57161 A, first and second electrodes, an MIM (Metal Insulator Metal) reflector, a resonator and an active element are formed on the semiconductor substrate. A horn opening is arranged between the first electrode and the second electrode.

BRIEF SUMMARY OF THE INVENTION

It is described in JP 2010-57161 A that the above-mentioned terahertz oscillation device enables an electromagnetic wave in a frequency band having a relatively wide bandwidth to be efficiently extracted in the horizontal direction with respect to the substrate.

However, in the terahertz oscillation device described in JP 2010-57161 A, the electromagnetic wave is attracted to the semiconductor substrate. Thus, a radiation direction of the electromagnetic wave is bent depending on an effective relative dielectric constant of the semiconductor substrate. Further, because antenna electrodes are formed on the semiconductor substrate, the radiation direction of the electromagnetic wave is determined by the influence of the semiconductor substrate. Thus, the electromagnetic wave cannot be efficiently radiated in a desired direction. Further, the radiation efficiency of the electromagnetic wave is low, and the transmission loss of the electromagnetic wave is large. Therefore, it is difficult to improve a transmission distance and a transmission speed.

In JP 2010-57161 A, it is suggested that the thickness of the semiconductor substrate is reduced in order to improve the radiation efficiency of the terahertz oscillation device. However, the terahertz oscillation device is easily damaged.

An object of the present invention is to provide an antenna module that is difficult to be damaged, capable of having a large degree of freedom of a directivity and capable of improving a transmission speed and a transmission distance.

(1) According to one aspect of the present invention, an antenna module includes a dielectric film that has first and second surfaces and is made of resin, an electrode formed on at least one of the first and second surfaces of the dielectric film to be capable of receiving and transmitting an electromagnetic wave in a terahertz band, and a semiconductor device mounted on at least one of the first and second surfaces of the dielectric film to be electrically connected to the electrode and operable in the terahertz band.

The terahertz band indicates a range of frequencies of not less than 0.05 THz and not more than 10 THz, for example, and preferably indicates a range of frequencies of not less than 0.1 THz and not more than 1 THz.

In the antenna module, the electromagnetic wave in the terahertz band is transmitted or received by the electrode formed on at least one surface of the first and second surfaces of the dielectric film. Further, the semiconductor device mounted on at least one of the first and second surfaces of the dielectric film performs detection and rectification, or oscillation.

Here, the dielectric film is formed of resin, so that an effective relative dielectric constant of the surroundings of the electrode is low. Thus, the electromagnetic wave radiated from the electrode or received by the electrode is less likely attracted to the dielectric film. Therefore, the antenna module can efficiently radiate the electromagnetic wave, and has the directivity in a substantially constant direction. In this case, the dielectric film is flexible, so that it is possible to obtain the directivity in a desired direction by bending the dielectric film. Thus, the antenna module can have a large degree of freedom of directivity.

Here, the transmission loss $\alpha$ [dB/m] of the electromagnetic wave is expressed in the following formula by a conductor loss $\alpha 1$ and a dielectric loss $\alpha 2$.

$$\alpha = \alpha 1 + \alpha 2 \ [dB/m]$$

Letting $\varepsilon_{ref}$ be an effective relative dielectric constant, f be a frequency, R(f) be conductor surface resistance and tan$\delta$ be a dielectric tangent, the conductor loss $\alpha 1$ and the dielectric loss $\alpha 2$ are expressed as below.

$$\alpha 1 \propto R(f) \cdot \sqrt{\varepsilon_{ref}} \ [dB/m]$$

$$\alpha 2 \propto \sqrt{\varepsilon_{ref}} \cdot \tan \delta \cdot f \ [dB/m]$$

From the above expressions, if the effective relative dielectric constant $\varepsilon_{ref}$ is low, the transmission loss $\alpha$ of the electromagnetic wave is reduced.
In the antenna module according to the present invention, because the effective relative dielectric constant of the surroundings of the electrode is low, the transmission loss of the electromagnetic wave is reduced. Thus, the transmission speed and the transmission distance can be improved.
Further, because the dielectric film is flexible, even when the thickness of the dielectric film is small, damage to the antenna module is difficult to be damaged.
Resin may include one or plurality of resin selected from the group consisting of polyimide, polyetherimide, polyamide-imide, polyolefin, cycloolefin polymer, polyarylate, polymethyl methacrylate polymer, liquid crystal polymer, polycarbonate, polyphenylene sulfide, polyether ether ketone, polyether sulfone, polyacetal, fluororesin, polyester, epoxy resin, polyurethane resin and urethane acrylic resin.
In this case, the dielectric film has sufficiently high flexibility and a sufficiently low relative dielectric constant. Therefore, the antenna module is difficult to be damaged, and the directivity in a desired direction can be easily obtained. Further, the transmission speed and the transmission distance can be sufficiently improved.

(2) The resin may include a porous resin. In this case, the relative dielectric constant of the dielectric film is further reduced. Thus, the transmission speed and the transmission distance can be further improved.
(3) The dielectric film may have a thickness of not less than 1$\mu$m and not more than 1000 $\mu$m. In this case, the dielectric film can be easily fabricated and the flexibility of the dielectric film can be easily ensured.
(4) The dielectric film may have a relative dielectric constant of not more than 7.0 in the terahertz band. In this case, the transmission speed and the transmission distance of the electromagnetic wave in the terahertz band can be sufficiently improved.

The semiconductor device may be mounted on the electrode by the flip-chip bonding. In this case, a bonding distance between the semiconductor device and the electrode is shortened, so that the semiconductor device can operate in the terahertz band with an even lower loss.
The semiconductor device may be mounted on the electrode by the wire bonding. Further, when a loss is kept sufficiently low in order for the semiconductor device to operate at a used frequency in the terahertz band, the mounting method of the semiconductor device is not limited to the above-mentioned mounting method.
The semiconductor device may include one or plurality of semiconductor devices selected from the group consisting of a resonant tunneling diode, a Schottky-barrier diode, a TUNNETT diode, an IMPATT diode, a high electron mobility transistor, a GaAs field effect transistor, a GaN field effect transistor (FET) and a Heterojunction Bipolar Transistor.
In this case, the semiconductor device can perform oscillation or detection, and rectification in the terahertz band.

(5) The electrode may include first and second conductive layers that constitute a tapered slot antenna having an opening, and the opening may have a width that continuously or gradually decreases from one end to another end of a set of the first and second conductive layers.

In this case, the antenna module can transmit or receive the electromagnetic wave at various frequencies in the terahertz band. Thus, transmission of an even larger bandwidth becomes possible. Further, because the tapered slot antenna has the directivity in a specific direction, it is possible to obtain the directivity in any direction by bending the antenna module.

(6) The width of the opening at the one end of each of the first and second conductive layers may be set such that one portion of the tapered slot has a width that enables transmission or receipt of the electromagnetic wave in the terahertz band.

In this case, the electromagnetic wave having a specific frequency in the terahertz band and an electromagnetic wave having another frequency can be transmitted or received.

(7) The electrode may include a conductive layer formed on the first surface of the dielectric film and a grounding conductive layer formed on the second surface of the dielectric film, and the conductive layer and the grounding conductive layer may constitute a patch antenna.

In this case, the directivity of the patch antenna differs depending on a frequency in the terahertz band. Further, the reflection loss at one or plurality of specific frequencies in the terahertz band is reduced. Therefore, the directivity in a desired direction can be obtained at a desired frequency in the terahertz band.

(8) The electrode may be formed on the first surface of the dielectric film, and the antenna module may further include a support body formed on the second surface of the dielectric film.

In this case, even when the thickness of the dielectric film is small, the shape-retaining property of the antenna module is ensured. Thus, the transmission direction or the reception direction of the electromagnetic wave can be fixed. Further, handleability of the antenna module is improved.

(9) The support body may be formed in a region that does not overlap with the electrode on the second surface. In this case, a change in directivity and the transmission loss of the electromagnetic wave due to the support body can be suppressed.

Other features, elements, characteristics, and advantages of the present invention will become more apparent from the following description of preferred embodiments of the present invention with reference to the attached drawings.

BRIEF DESCRIPTION OF THE SEVERAL VIEWS OF THE DRAWING

Fig. 1 is a schematic plan view of an antenna module according to a first embodiment of the present invention;
Fig. 2 is a schematic cross sectional view taken along the line A-A of the antenna module of Fig. 1;
Fig. 3 is a schematic diagram showing the mounting of a semiconductor device by a flip-chip mounting method;
Fig. 4 is a schematic diagram showing the mounting of the semiconductor device by a wire bonding mounting method;
Fig. 5 is a schematic plan view showing the reception operation of the antenna module according to the present embodiment;
Fig. 6 is a schematic plan view showing the transmission operation of the antenna module according to the present embodiment;
Fig. 7 is a schematic side view for explaining the directivity of the antenna module according to the present embodiment;
Fig. 8 is a schematic side view for explaining the change in directivity of the antenna module according to the present embodiment;
Fig. 9 is a schematic plan view showing the first modified example of the antenna module according to the present embodiment;
Fig. 10 is a schematic perspective view showing the second modified example of the antenna module according to the present embodiment;
Fig. 11 is a schematic plan view for explaining the measurement of the antenna module used for simulation and an experiment;
Fig. 12 is a diagram showing the simulation results of the relationship between the thickness of the dielectric film and radiation efficiency;
Fig. 13 is a diagram showing the simulation results of the relationship between a relative dielectric constant of the dielectric film and the radiation efficiency;
Fig. 14 is a block diagram showing the configuration of the evaluation system of the antenna module;
Fig. 15 is a diagram showing the measurement results of a BER at the time of transmission of the terahertz wave of 0.12 THz and 0.3 THz;
Fig. 16 is a diagram showing an eye pattern of a baseband signal observed by an oscilloscope at the time of transmission of the terahertz wave of 0.12 THz;

Fig. 17 is a diagram showing the eye pattern of the baseband signal observed by the oscilloscope at the time of transmission of the terahertz wave of 0.3 THz;

Fig. 18 is a diagram showing the measurement results of the BER obtained when the data transmission speed is 8.5 Gbps;

Fig. 19 is a diagram showing the eye pattern of the baseband signal observed by the oscilloscope when the data transmission speed is 8.5 Gbps;

Fig. 20 is a schematic diagram for explaining the definition of an reception angle of the antenna module in an experiment and simulation;

Fig. 21 is a diagram showing the measurement results of the horizontal distance dependence of directivity of the antenna module;

Fig. 22 is a diagram showing the measurement results of directivity at the time of receiving the terahertz wave of 0.12 THz;

Fig. 23 is a diagram showing the measurement results of directivity at the time of receiving the terahertz wave of 0.3 THz;

Fig. 24 is a diagram showing the measurement results and the calculation results of directivity at the time of receiving the terahertz wave of 0.3 THz;

Figs. 25(a) and 25(b) are diagrams showing the results of three-dimensional electromagnetic field simulation obtained when the antenna module is not bent;

Figs. 26(a) and 26(b) are diagrams showing the results of the three-dimensional electromagnetic field simulation obtained when the antenna module is bent;

Fig. 27 is a diagram showing the calculation results of antenna gain obtained when the antenna module is not bent and when the antenna module is bent;

Fig. 28 is a schematic plan view of the antenna module according to the second embodiment of the present invention;

Fig. 29 is a schematic sectional view taken along the line B-B of the antenna module of Fig. 28;

Fig. 30 is a diagram for explaining the definition of the direction of the antenna module;

Figs. 31 (a) to 31 (d) are diagrams showing the results of the three-dimensional field simulation of the antenna module of Fig. 28;

Fig. 32 is a diagram showing the calculation results of the reflection loss of the antenna module of Fig. 28;

Fig. 33 is a schematic plan view showing a modified example of the antenna module according to the present embodiment;

Fig. 34 is a diagram for explaining the definition of the direction of the antenna module;

Figs. 35(a) to 35(c) are diagrams showing the results of the three-dimensional electromagnetic field simulation of the antenna module of Fig. 33;

Fig. 36 is a diagram showing the calculation results of the reflection loss of the antenna module of Fig. 33;

Fig. 37 is a schematic plan view of the antenna module according to the third embodiment of the present invention;

Fig. 38 is a schematic cross sectional view taken along the line B-B of the antenna module of Fig. 37;

Fig. 39 is a schematic perspective view of the antenna module of Fig. 37;

Figs. 40(a) to 40(e) are schematic sectional views for use in illustrating steps in a method of manufacturing the antenna module of Fig. 37;

Figs. 41 (a) and 41 (b) are diagrams showing the calculation results of the change in antenna gain obtained when a distance between a support body and an electrode is changed;

Figs. 42(a) and 42(b) are diagrams showing the calculation results of the change in antenna gain obtained when the distance between the support body and the electrode is changed;

Fig. 43 is a diagram showing the calculation results of the maximum antenna gain obtained when the frequency of the electromagnetic wave is changed from 0.15 THz to 0.30 THz; and

Figs. 44(a) and 44(b) are diagrams showing the calculation results of the antenna gain obtained when the antenna module has the support body and when the antenna module does not have the support body.

## DESCRIPTION OF THE PREFERRED EMBODIMENTS

An antenna module according to embodiments of the present invention will be described below. In the following description, a frequency band from 0.05 THz to 10 THz is referred to as the terahertz band. The antenna module according to the embodiments can transmit and receive an electromagnetic wave having at least a specific frequency in the terahertz band.

(1) First Embodiment

(1-1) Configuration of Antenna Module

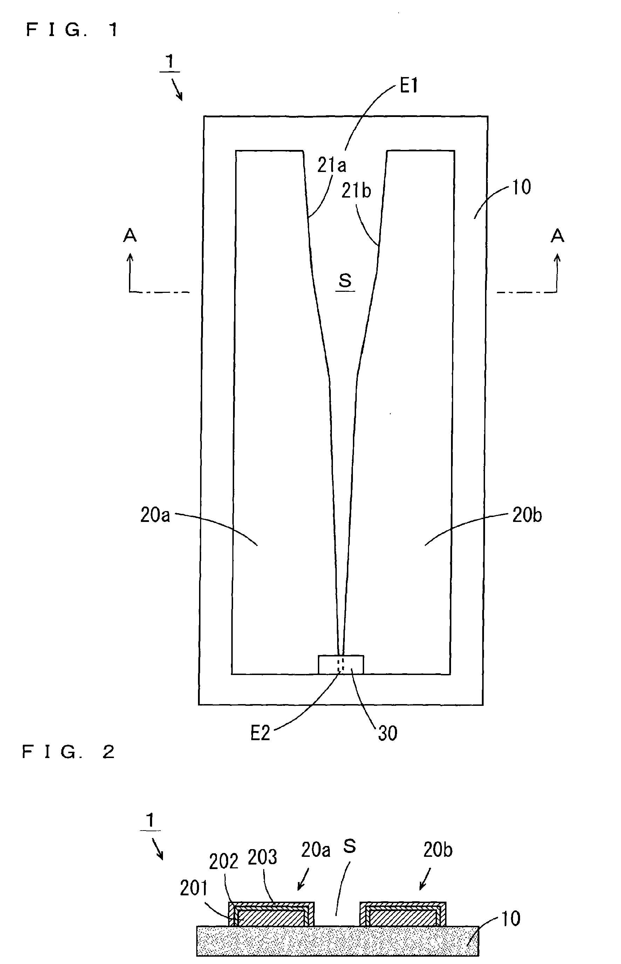

Fig. 1 is a schematic plan view of the antenna module according to the first embodiment of the present invention. Fig. 2 is a schematic cross sectional view taken along the line A-A of the antenna module of Fig. 1.

In Fig. 1, the antenna module 1 is constituted by a dielectric film 10, a pair of electrodes 20a, 20b and a semiconductor device 30. The dielectric film 10 is formed of resin that is made of polymer. One surface of the two surfaces of the dielectric film 10 opposite to each other is referred to as a main surface, and the other surface is referred to as a back surface. In the present embodiment, the main surface is an example of a first surface, and the back surface is an example of a second surface.

The pair of electrodes 20a, 20b is formed on the main surface of the dielectric film 10. A gap that extends from one end to the other end of a set of the electrodes 20a, 20b is provided between the electrodes 20a, 20b. End surfaces 21a, 21b of the electrodes 20a, 20b that face each other are formed in a tapered shape such that the width of the gap continuously or gradually decreases from the one end to the other end of a set of the electrodes 20a, 20b. The gap between the electrodes 20a, 20b is referred to as a tapered slot S. The electrodes 20a, 20b constitute a tapered slot antenna. The dielectric film 10 and the electrodes 20a, 20b are formed of a flexible printed circuit board. In this case, the electrodes 20a, 20b are formed on the dielectric film 10 using a subtractive method, an additive method or a semi-additive method. If a below-mentioned semiconductor device 30 can be appropriately mounted, the electrodes 20a, 20b may be formed on the dielectric film 10 using another method. For example, the electrodes 20a, 20b may be formed by patterning a conductive material on the dielectric film 10 using a screen printing method, an ink-jet method or the like.

Here, the dimension in the direction of a central axis of the tapered slot S is referred to as length, and the dimension in the direction parallel to the main surface of the dielectric film 10 and orthogonal to the central axis of the tapered slot S is referred to as width. The end of the tapered slot S having the maximum width is referred to as an opening end E1, and the end of the tapered slot S having the minimum width is referred to as a mount end E2. Further, a direction directed from the mount end E2 toward the opening end E1 of the antenna module 1 and extends along the central axis of the tapered slot S is referred to as a central axis direction.

The semiconductor device 30 is mounted on the ends of the electrodes 20a, 20b at the mount end E2 using a flip chip mounting method or a wire bonding mounting method. One terminal of the semiconductor device 30 is electrically connected to the electrode 20a, and another terminal of the semiconductor device 30 is electrically connected to the electrode 20b. The mounting method of the semiconductor device 30 will be described below. The electrode 20b is to be grounded.

As the material for the dielectric film 10, one or more types of porous resins or non-porous resins out of polyimide, polyetherimide, polyamide-imide, polyolefin, cycloolefin polymer, polyarylate, polymethyl methacrylate polymer, liquid crystal polymer, polycarbonate, polyphenylene sulfide, polyether ether ketone, polyether sulfone, polyacetal, fluororesin, polyester, epoxy resin, polyurethane resin and urethane acrylic resin (acryl resin) can be used.

Fluororesin includes polytetrafluoroethylene, polyvinylidene fluoride, ethylene-tetrafluoroethylene copolymer, perfluoro-alkoxy fluororesin, fluorinated ethylene-propylene copolymer (tetrafluoroethylene-hexafluoropropylene copolymer) or the like. Polyester includes polyethylene terephthalate, polyethylene naphthalate, polybutylene terephthalate or the like.

In the present embodiment, the dielectric film 10 is formed of polyimide.

The thickness of the dielectric film 10 is preferably not less than 1 $\mu$m and not more than 1000 $\mu$m. In this case, the dielectric film 10 can be easily fabricated and flexibility of the dielectric film 10 can be easily ensured. The thickness of the dielectric film 10 is more preferably not less than 5 $\mu$m and not more than 100 $\mu$m. In this case, the dielectric film 10 can be more easily fabricated and higher flexibility of the dielectric film 10 can be easily ensured. In the present embodiment, the thickness of the dielectric film 10 is 25 $\mu$m, for example.

The dielectric film 10 preferably has a relative dielectric constant of not more than 7.0, and more preferably has a relative dielectric constant of not more than 4.0, in a used frequency within the terahertz band. In this case, the radiation efficiency of an electromagnetic wave having the used frequency sufficiently is increased and the transmission loss of the electromagnetic wave is sufficiently reduced. Thus, the transmission speed and the transmission distance of the electromagnetic wave having the used frequency can be sufficiently improved. In the present embodiment, the dielectric film 10 is formed of resin having a relative dielectric constant of not less than 1.2 and not more than 7.0 in the terahertz band. The relative dielectric constant of polyimide is about 3.2 in the terahertz band, and the relative dielectric constant of porous polytetrafluoroethylene (PTFE) is about 1.2 in the terahertz band.

The electrodes 20a, 20b may be formed of a conductive material such as metal or an alloy. The electrodes 20a, 20b may have single layer structure or laminate structure of a plurality of layers.

In the present embodiment, as shown in Fig. 2, each of the electrodes 20a, 20b has the laminate structure of a copper layer 201, a nickel layer 202 and a gold layer 203. The thickness of the copper layer 201 is 15 $\mu$m, for example,

the thickness of the nickel layer 203 is 3 μm, for example and the thickness of the gold layer 203 is 0.2 μm, for example. The material and the thickness of the electrodes 20a, 20b are not limited to the examples of the present embodiment.

In the present embodiment, the laminate structure of Fig. 2 is adopted to perform the flip chip mounting by Au stud bumps and a wire bonding mounting by Au bonding wires, mentioned below. Formation of the nickel layer 202 and the gold layer 203 is surface processing for the copper layer 201 in a case in which the afore-mentioned mounting methods are used. When another mounting method using solder balls, ACFs (anisotropic conductive films), ACPs (anisotropic conductive pastes) or the like are used, processing appropriate for respective mounting method is selected.

One or plurality of semiconductor devices selected from a group constituted by a resonant tunneling diode (RTD), a Schottky-barrier diode (SBD), a TUNNETT (Tunnel Transit Time) diode, an IMPATT (Impact Ionization Avalanche Transit Time) diode, a high electron mobility transistor (HEMT), a GaAs field effect transistor (FET), a GaN field effect transistor (FET) and a Heterojunction Bipolar Transistor (HBT) is used as the semiconductor device 30. These semiconductor devices are active elements. A quantum element, for example, can be used as the semiconductor device 30. In the present embodiment, the semiconductor device 30 is a Schottky-barrier diode.

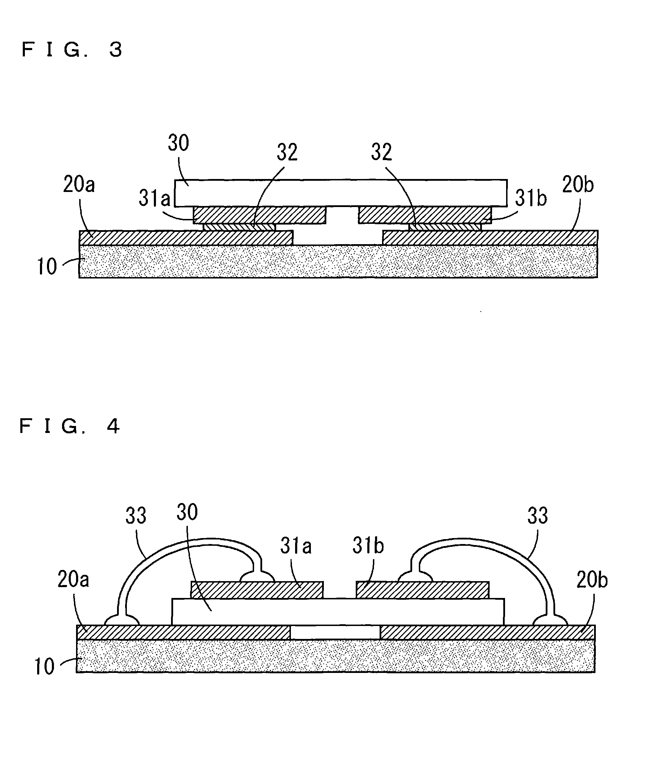

Fig. 3 is a schematic diagram showing the mounting of the semiconductor device 30 using the flip chip mounting method. As shown in Fig. 3, the semiconductor device 30 has terminals 31a, 31b. The terminals 31a, 31b are an anode and a cathode of a diode, for example. The semiconductor device 30 is positioned above the electrodes 20a, 20b such that the terminals 31a, 31b are directed downward, and the terminals 31a, 31b are bonded to the electrodes 20a, 20b using Au stud bumps 32, respectively.

Fig. 4 is a schematic diagram showing the mounting of the semiconductor device 30 using the wire bonding mounting method. As shown in Fig. 4, the semiconductor device 30 is positioned on the electrodes 20a, 20b such that the terminals 31a, 31b are directed upward, and the terminals 31a, 31b are respectively connected to the electrodes 20a, 20b using Au bonding wires 33.

In the antenna module 1 of Fig. 1, an area from the opening end E1 of the taper slot S to the mount portion for the semiconductor device 30 functions as a transmitter/receiver that transmits or receives the electromagnetic wave. The frequency of the electromagnetic wave transmitted or received by the antenna module 1 is determined by the width of the taper slot S and an effective dielectric constant of the tapered slot S. The effective dielectric constant of the tapered slot S is calculated based on the relative dielectric constant of the air between the electrodes 20a, 20b, and the relative dielectric constant and the thickness of the dielectric film 10.

Generally, a wavelength λ of the electromagnetic wave in a medium is expressed in the following formula.

$$\lambda = \lambda_0 / \sqrt{\varepsilon_{ref}}$$

$\lambda_0$ is a wavelength of the electromagnetic wave in a vacuum, and $\varepsilon_{ref}$ is an effective relative dielectric constant of the medium. Therefore, if the effective relative dielectric constant of the tapered slot S increases, a wavelength of the electromagnetic wave in the tapered slot S is shortened. In contrast, if the effective relative dielectric constant of the tapered slot S decreases, a wavelength of the electromagnetic wave in the tapered slot S is lengthened. When the effective relative dielectric constant of the tapered slot S is assumed to be minimum 1, the electromagnetic wave of 0.1 THz is transmitted or received at a portion where the width of the tapered slot S is 1.5 mm. The tapered slot S preferably includes a portion having the width of 2mm in consideration of a margin.

The length of the tapered slot S is preferably not less than 0.5 mm and not more than 30 mm. A mount area for the semiconductor device 30 can be ensured when the length of the tapered slot S is not less than 0.5 mm. Further, the length of the tapered slot S is preferably not more than 30 mm on the basis of 10 wavelengths.

(1-2) Operation of Antenna Module

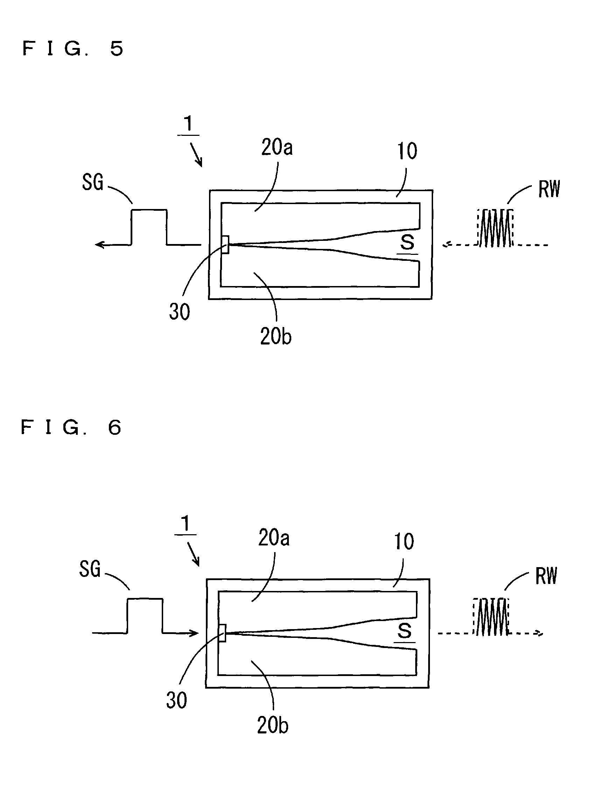

Fig. 5 is a schematic plan view showing the reception operation of the antenna module 1 according to the present embodiment. In Fig. 5, an electromagnetic wave RW includes a digital intensity modulated signal wave having a frequency (0.3 THz, for example) in the terahertz band and a signal wave having a frequency (1GHz, for example) in a gigahertz band. The electromagnetic wave RW is received in the tapered slot S of the antenna module 1. Thus, an electric current having a frequency component in the terahertz band flows in the electrodes 20a, 20b. The semiconductor device 30 performs detection and rectification. Thus, a signal SG having a frequency (1GHz, for example) in the gigahertz band is output from the semiconductor device 30.

Fig. 6 is a schematic plan view showing the transmission operation of the antenna module 1 according to the present embodiment. In Fig. 6, the signal SG having a frequency (1GHz, for example) in the gigahertz band is input to the semiconductor device 30. The semiconductor device 30 performs oscillation. Thus, the electromagnetic wave RW is transmitted from the tapered slot S of the antenna module 1. The electromagnetic wave RW includes the digital intensity modulated signal wave having a frequency (0.3 THz, for example) in the terahertz band and a signal wave having a frequency (1GHz, for example) in the gigahertz band.

(1-3) Directivity of Antenna Module

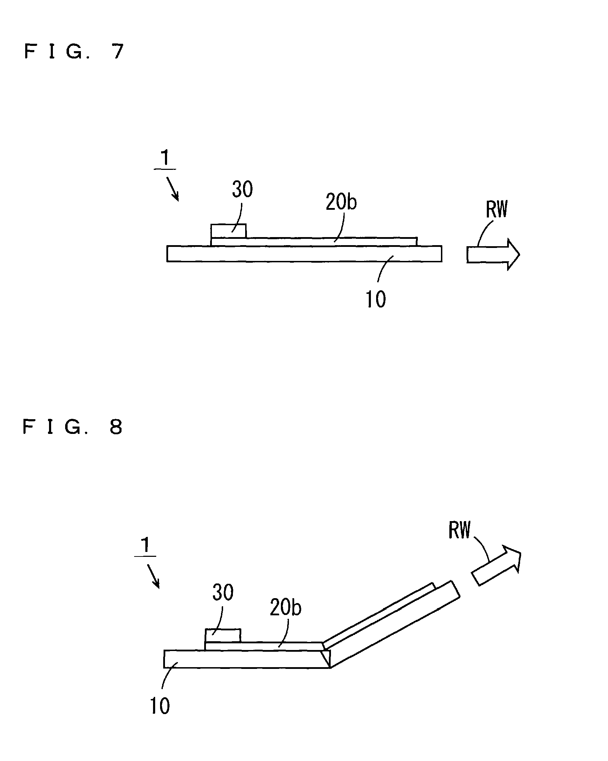

Fig. 7 is a schematic side view for explaining the directivity of the antenna module 1 according to the present embodiment.

In Fig. 7, the antenna module 1 radiates a carrier wave modulated by the signal wave as the electromagnetic wave RW. In this case, because the relative dielectric constant of the dielectric film 10 is low, the electromagnetic wave RW is not attracted to the dielectric film 10. Therefore, the electromagnetic wave RW advances in the central axis direction of the antenna module 1.

Fig. 8 is a schematic side view for explaining the change in directivity of the antenna module 1 according to the present embodiment.

The dielectric film 10 of the antenna module 10 is flexible. Therefore, the antennal module 1 can be bent along an axis that intersects with the central axis direction. Thus, as shown in Fig. 8, the radiation direction of the electromagnetic wave RW can be changed to any direction.

(1-4) First Modified Example of Antenna Module

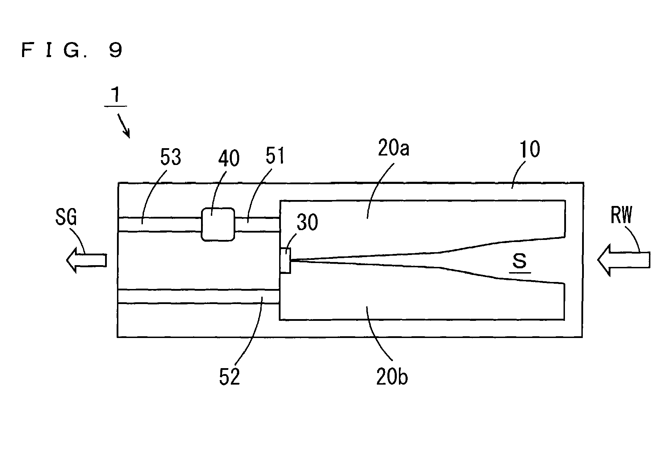

Fig. 9 is a schematic plan view showing the first modified example of the antenna module 1 according to the present embodiment.

The antenna module 1 shown in Fig. 9 further includes signal wirings 51, 52, 53 and a low-pass filter 40 on the dielectric film 10. The signal wiring 51 is connected to the electrode 20a, and the signal wiring 52 is connected to the electrode 20b. The low-pass filter 40 is connected between the signal wiring 51 and the signal wiring 53. This low-pass filter 40 is formed of a meander wiring, a gold wire or the like, for example. The low-pass filter 40 passes only low frequency components of not more than a specific frequency (20GHz, for example) that is a signal component in the gigahertz band.

The electrodes 20a, 20b, the low-pass filter 40 and the signal wirings 51, 52, 53 are formed on the dielectric film 10 in the common step using the subtractive method, the additive method or the semi-additive method, or by patterning a conductive material.

The electromagnetic wave RW includes the carrier wave having a frequency in the terahertz band and the signal wave having a frequency in the gigahertz band. This electromagnetic wave RW is received at the tapered slot S of the antenna module 1. A signal having a frequency in the gigahertz band is output to the signal wirings 51, 52 from the semiconductor device 30. At this time, part of a frequency component in the terahertz band may be transmitted from the electrodes 20a, 20b to the signal wirings 51, 52. In this case, the low-pass filter 40 blocks the frequency component in the terahertz band from passing. Thus, only the signal SG having a frequency (about 20GHz, for example) in the gigahertz band is output to the signal wirings 51, 53.

(1-5) Second Modified Example of Antenna Module

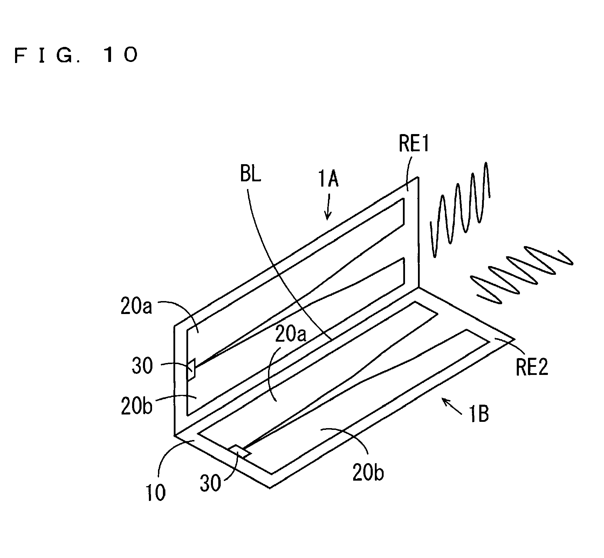

Fig. 10 is a schematic perspective view showing the second modified example of the antennal module according to the present embodiment.

In the example of Fig. 10, two sets of tapered slot antenna modules 1A, 1B are fabricated using a common dielectric film 10. The dielectric film 10 has rectangular first and second regions RE1, RE2 that are adjacent to each other.

One pair of electrodes 20a, 20b is formed in the first region RE1, and one semiconductor device 30 is mounted on the electrodes 20a, 20b. The first region RE1 of the dielectric film 10, and the electrodes 20a, 20b and the semiconductor device 30 on the first region RE1 constitute the antenna module 1A.

Similarly, another pair of electrodes 20a, 20b is formed in the second region RE2, and another semiconductor device 30 is mounted on the electrodes 20a, 20b. The second region RE2 of the dielectric film 10, and the electrodes 20a, 20b and the semiconductor device 30 on the second region RE2 constitute the antenna module 1B.

The dielectric film 10 is bent at a right angle along a boundary line BL between the first region RE1 and the second region RE2.

A plane of polarization of the electromagnetic wave radiated from the antenna module 1A and a plane of polarization of the electromagnetic wave radiated from the antenna module 1B are orthogonal to each other. Here, the plane of polarization of the electromagnetic wave refers to a plane that includes a vibration direction and a propagation direction of the electric field of the electromagnetic wave.

The vibration direction of the electromagnetic wave radiated by the antenna module 1A and the vibration direction of the electromagnetic wave radiated by the antenna module 1B differ by 90°. Therefore, the electromagnetic waves radiated by the antenna modules 1A, 1B do not interfere with each other. Thus, it is possible to transmit or receive different polarized waves without changing the directivity of the antenna modules 1A, 1B.

(1-6) Characterization of Antenna Module

Characteristics of the antenna module 1 according to the present embodiment were evaluated by simulation and an experiment.

(a) Dimensions of Antenna Module 1

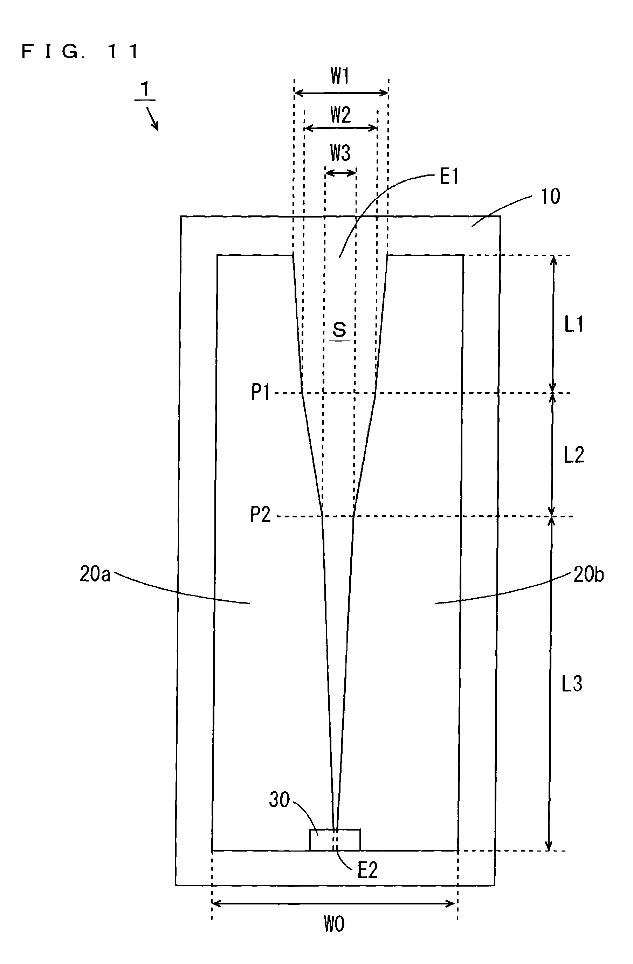

Fig. 11 is a schematic plan view for explaining the dimensions of the antenna module 1 used for the simulation and the experiment.
The distance WO between the outer end edges of the electrodes 20a, 20b in the width direction is 2.83 mm. The width W1 of the tapered slot S at the opening end E1 is 1.11 mm. The widths W2, W3 of the tapered slot S at positions P1, P2 between the opening end E1 and the mount end E2 are 0.88 mm and 0.36 mm, respectively. The length L1 between the opening end E1 and the position P1 is 1.49 mm, and the length L2 between the position P1 and the position P2 is 1.49 mm. The length L3 between the position P2 and the mount end E2 is 3.73 mm. The width of the tapered slot S at the mount end E2 is 50 $\mu$m.

(b) Simulation of Radiation Efficiency

The radiation efficiency at 300 GHz were found by the electric field simulation using polyimide, porous PTFE and InP that are semiconductor materials as the material for the dielectric film 10, provided that the thickness of the dielectric film 10 is 25 $\mu$m, 100 $\mu$m, 250 $\mu$m, 500 $\mu$m and 1000 $\mu$m. The value of the relative dielectric constant of polyimide was considered as 3.2, the value of the relative dielectric constant of porous PTFE was considered as 1.6, and the value of the relative dielectric constant of InP was considered as 12.4.
Radiation efficiency is expressed in the following formula.

$$\text{Radiation efficiency} = \text{Radiation Power/Supply Power}$$

The supply power is the electric power supplied to the antenna module 1. The radiation power is the electric power radiated from the antenna module 1. In the present simulation, the supply power is 1 mW.

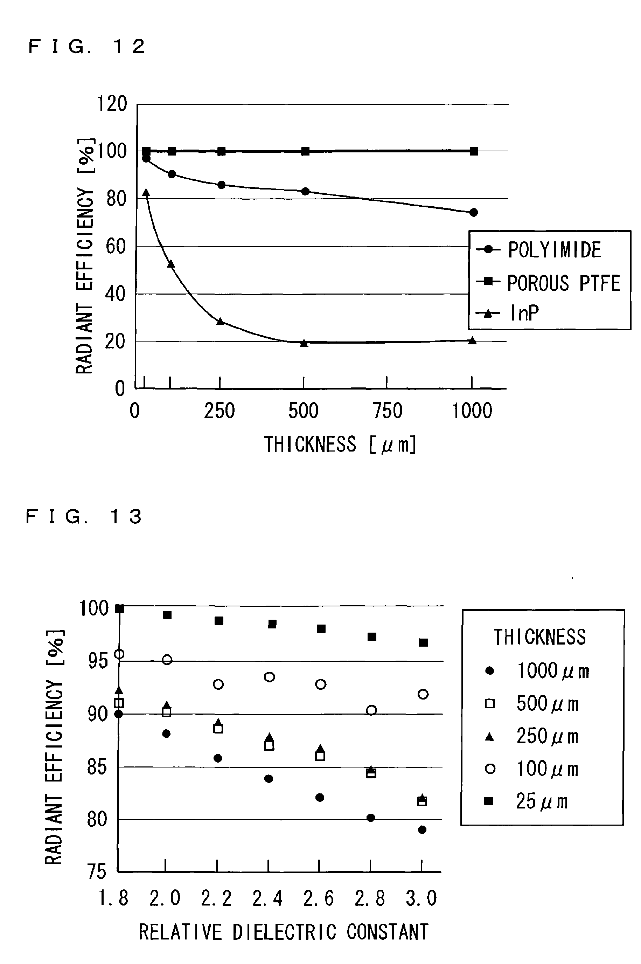

Fig. 12 is a diagram showing the simulation results of the relationship between the thickness of the dielectric film 10 and the radiation efficiency at 300GHz. The ordinate of Fig. 12 indicates the radiation efficiency, and the abscissa indicates the thickness of the dielectric film 10.
As shown in Fig. 12, when porous PTFE is used as the material for the dielectric film 10, the radiation efficiency of substantially 100% is obtained with the thickness of the dielectric film 10 being in a range from 25 $\mu$m to 1000 $\mu$m. When polyimide is used as the material for the dielectric film 10, the radiation efficiency of substantially not less than 75% is obtained with the thickness of the dielectric film 10 being in a range from 25 $\mu$m to 1000 $\mu$m. When InP is used as the material for the dielectric film 10, the radiation efficiency sharply decreases as the thickness of the dielectric film 10 increases from 25 $\mu$m to 250 $\mu$m. When the thickness of the dielectric film 10 is more than 500 $\mu$m, the radiation efficiency decreases to approximately 20%.
Therefore, it is found that when resin is used as the material for the dielectric film 10, the radiation efficiency is high in a wide range of the thickness of the dielectric film 10, as compared to a case in which a semiconductor material is used as the material for the dielectric film 10. It is found that when porous resin is used in particular, the radiation efficiency is high regardless of the thickness of the dielectric film 10.
Meanwhile, at the time of mounting the semiconductor device 30 on a semiconductor substrate such as InP, the thickness of the semiconductor substrate is preferably at least 200 $\mu$m. If the thickness of the semiconductor substrate is less than 200 $\mu$m, it is difficult to handle the semiconductor device 30, and the semiconductor substrate is easy to be damaged. From the above results, if the thickness of the semiconductor substrate is not less than 200 $\mu$m, the radiation efficiency decreases to not more than about 30%.
Next, the radiation efficiency at 300 GHz was found by the electromagnetic field simulation, provided that the relative dielectric constant of the dielectric film 10 is 1.8, 2.0, 2.2, 2.4, 2.6, 2.8 and 3.0.
Fig. 13 is a diagram showing the simulation results of the relationship between the relative dielectric constant of the dielectric film 10 and the radiation efficiency at 300 GHz.
As shown in Fig. 13, the lower the relative dielectric constant of the dielectric film 10 is, the higher the radiation efficiency is. Further, the smaller the thickness of the dielectric film 10 is, the higher the radiation efficiency is.

(c) Evaluation System of Antenna Module 1

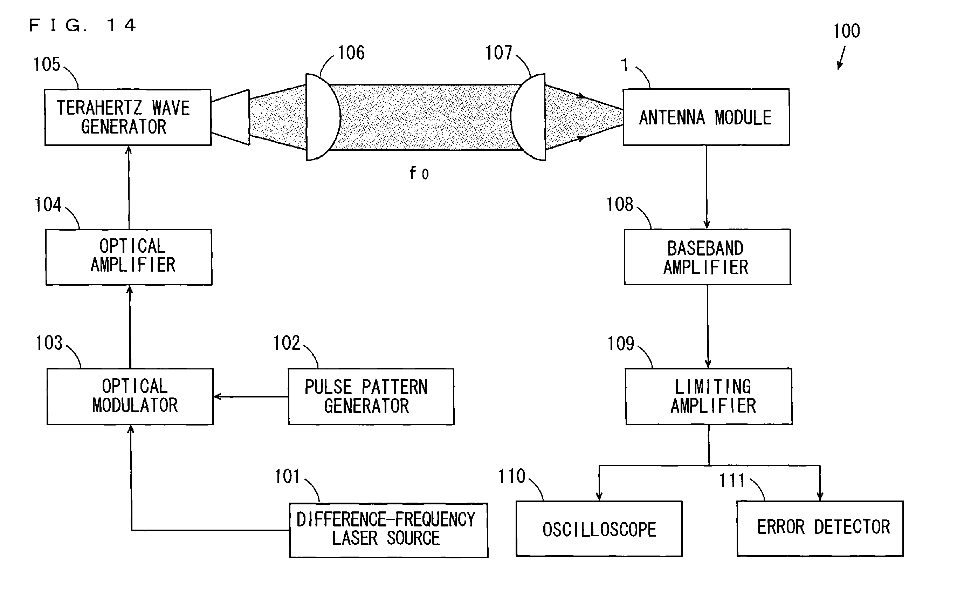

Fig. 14 is a block diagram showing the configuration of the evaluation system of the antenna module 1.

In the evaluation system of Fig. 14, a difference-frequency laser source 101 mixes two types of laser light having different frequencies $f_1$, $f_2$, thereby generating an optical beat signal having a frequency $f_b$ ($=f_1-f_2$) that is the difference between those frequencies $f_1$, $f_2$. In the present experiment, the difference-frequency laser source 101 generates the optical beat signals of 0.12 THz and 0.3 THz.

A pulse pattern generator 102 generates an electric signal having a pulse pattern as a baseband signal. An optical modulator 103 modulates the amplitude of the optical beat signal generated by the difference-frequency laser source 101 with the baseband signal generated by the pulse pattern generator 102. The modulated optical beat signal is supplied to a terahertz wave generator 105 as a terahertz optical signal through an optical amplifier 104.

The terahertz wave generator 105 includes a collimator lens, a high frequency photodiode, a quartz coupler and a waveguide.

The terahertz optical signal is supplied to the high frequency photodiode of the terahertz wave generator 105 through the collimator lens. Thus, an ultrahigh-frequency current is output from the high frequency photodiode. The ultrahigh-frequency current is radiated by the quartz coupler and the waveguide as a terahertz wave. Here, the terahertz wave refers to an electromagnetic wave having a frequency in the terahertz band.

The terahertz wave radiated by the terahertz wave generator 105 is received by the antenna module 1 of Fig. 11 through dielectric lenses 106, 107 that are arranged to be spaced apart a predetermined distance from each other. The dielectric film 10 of the antenna module 1 is formed of polyimide, and a Schottky-barrier diode is mounted as the semiconductor device 30 using the flip-chip mounting method.

The antenna module 1 demodulates the baseband signal by detecting and rectifying the terahertz wave. A baseband amplifier 108 amplifies the baseband signal that is output from the antenna module 1. A limiting amplifier 109 amplifies the baseband signal such that the voltage amplitude of the baseband signal is a predetermined value (0.5V, for example).

An oscilloscope 110 displays a waveform of the baseband signal that is output from the limiting amplifier 109. An error detector 111 detects a BER (Bit Error Rate) in the baseband signal that is output from the limiting amplifier 109.

(d) Experiment of Transmission

The experiment of transmission of the terahertz waves of 0.12 THz and 0.3 THz was performed in the evaluation system of Fig. 14. The transmission distance of the terahertz wave in this experiment of transmission is about 1 m.

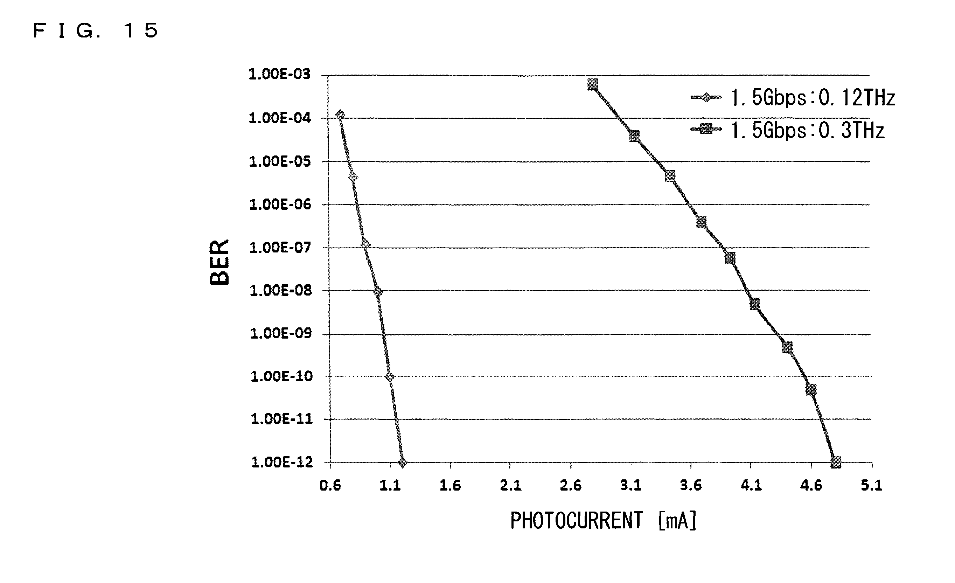

Fig. 15 is a diagram showing the measurement results of the BER at the time of transmission of the terahertz waves of 0.12 THz and 0.3 THz. The ordinate of Fig. 15 indicates the BER detected by the error detector 111, and the abscissa indicates an photocurrent of the terahertz optical signal supplied to the high frequency photodiode of the terahertz wave generator 105.

In the present experiment, the transmission speed of data was 1.5 Gbps. When the BER is not more than 1.00 x $10^{-12}$, it can be considered that the data transmission without an error is realized.

As shown in Fig. 15, at the time of transmission of the terahertz wave of 0.12 THz, it is possible to reduce the BER to 1.00 x $10^{-12}$ by adjusting the photocurrent to 1.2 mA. Further, at the time of transmission of the terahertz wave of 0.3 THz, it is possible to reduce the BER to 1.00 x $10^{-12}$ by adjusting the photocurrent to 4.8 mA.

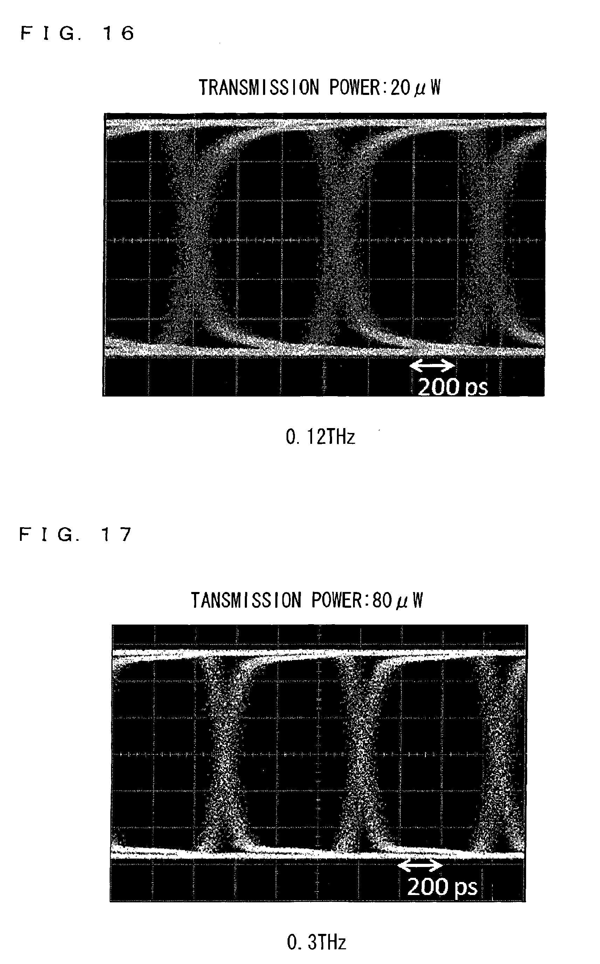

Fig. 16 is a diagram showing an eye pattern of the baseband signal observed by the oscilloscope 110 at the time of transmission of the terahertz wave of 0.12 THz. Fig. 17 is a diagram showing an eye pattern of the baseband signal observed by the oscilloscope 110 at the time of transmission of the terahertz wave of 0.3 THz. The transmission power of the terahertz wave of 0.12 THz is 20 $\mu$W, and the transmission power of the terahertz wave of 0.3 THz is 80 $\mu$W.

As shown in Figs. 16 and 17, at the time of transmission of the terahertz waves of 0.12 THz and 0.3 THz, the baseband signal having little distortion is demodulated.

The above result shows that the data transmission without an error is possible in transmission of the terahertz waves of both 0.12 THz and 0.3 THz. Therefore, the antenna module 1 according to the present embodiment enables the transmission of a terahertz wave of a wide band.

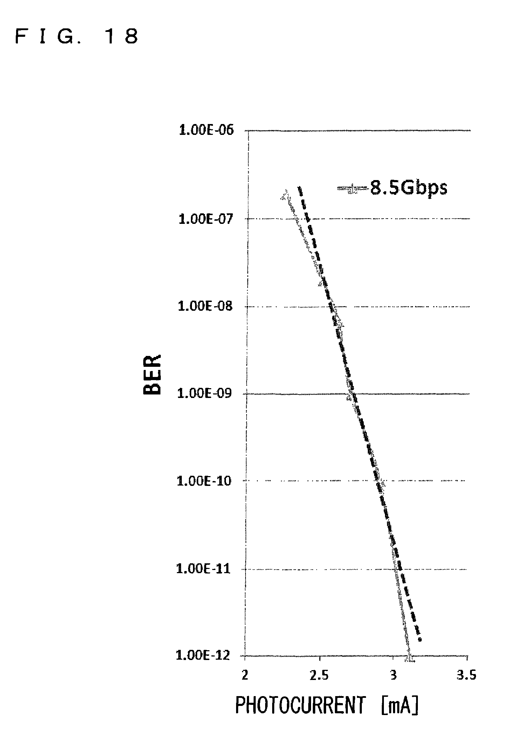

Next, the maximum transmission speed was evaluated in the evaluation system of Fig. 14. Fig. 18 is a diagram showing the measurement results of the BER obtained when the data transmission speed is 8.5 Gbps. The frequency of the terahertz wave is 0.12THz. The ordinate of Fig. 18 indicates the BER detected by the error detector 111, and the abscissa indicates the photocurrent of the terahertz optical signal supplied to the high frequency photodiode of the terahertz wave generator 105.

As shown in Fig. 18, even when the data transmission speed is 8.5 Gbps, it is possible to reduce the BER to

$1.00 \times 10^{-12}$ by adjusting the photocurrent to 3.1 mA.

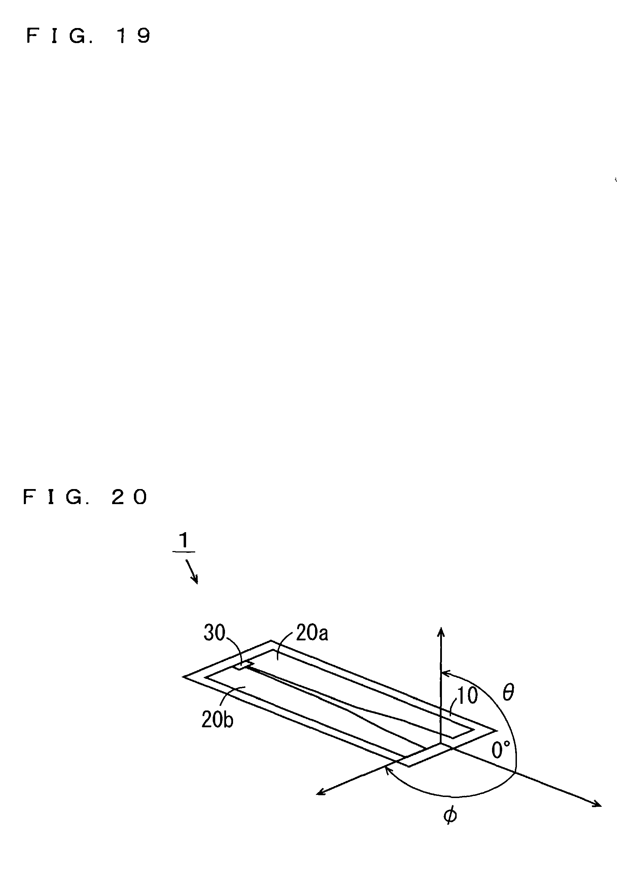

Fig. 19 is a diagram showing an eye pattern of the baseband signal observed by the oscilloscope 110 when the data transmission speed is 8.5 Gbps. As shown in Fig. 19, even at the time of data transmission of 8.5 Gbps, the baseband signal is demodulated.

The above results show that the data transmission without an error is possible even at the data transmission speed of 8.5 Gbps. Therefore, the antenna module 1 according to the present embodiment enables the transmission of a terahertz wave at a high data transmission speed of 8.5 Gbps.

(e) Measurement and Calculation of Directivity of Antenna Module

Next, a measurement experiment of the directivity of the antenna module 1 of Fig. 11 was performed. In the experiment, the terahertz wave of 0.3 THz was transmitted using a 300GHz transmitter, and the terahertz wave was received by the antenna module 1. The received power at the antenna module 1 was measured by a spectrum analyzer with the reception angle of the antenna module 1 being changed by 180° in steps of 5°. Further, the directivity of the antenna module 1 of Fig. 11 was calculated by the electromagnetic field simulation.

Fig. 20 is a schematic diagram for explaining the definition of the reception angle of the antenna module 1 in the experiment and simulation.

In Fig. 20, the central axis direction of the antenna module 1 is 0°. Further, a plane parallel to the main surface of the dielectric film 10 is referred to as a parallel plane, and a plane vertical to the main surface of the dielectric film 10 is referred to as a vertical plane.

An angle formed with respect to the central axis direction in the parallel plane is referred to as an azimuth angle $\phi$, and an angle formed with respect to the central axis direction in the vertical plane is referred to as an elevation angle $\theta$.

A horizontal distance between the transmitter and the antenna module 1 was set to 4.5 cm and 9 cm, and the horizontal distance dependence of the directivity of the antenna module 1 was measured. Here, the horizontal distance is a distance between the transmitter and the antenna module 1 in the central axis direction of the antenna module 1. In this case, the azimuth angle $\phi$ was changed by 180° in steps of 5° as the reception angle of the antenna module 1, and the received power at the antenna module 1 was measured.

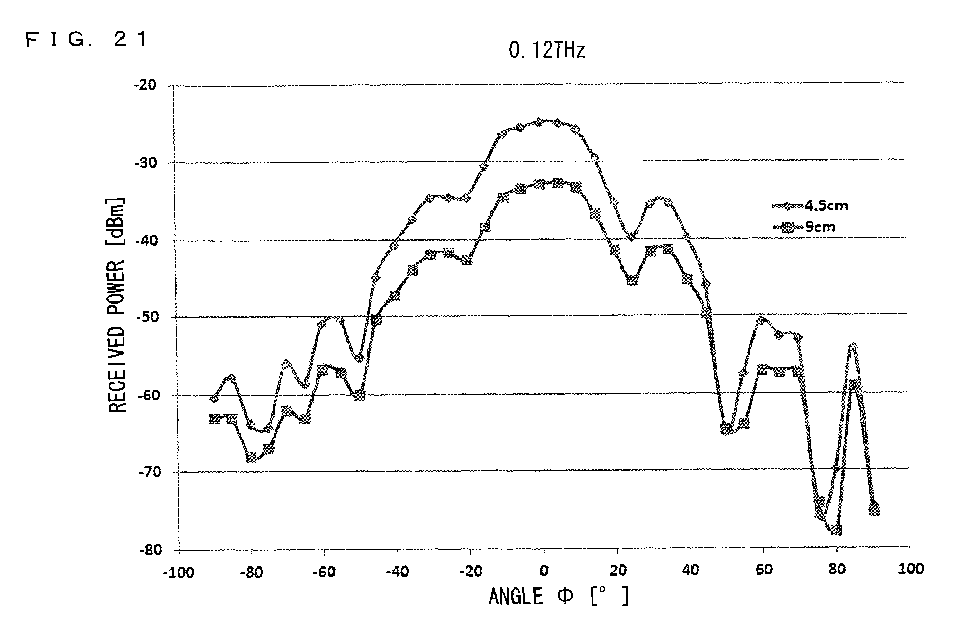

Fig. 21 is a diagram showing the measurement results of the horizontal distance dependence of the directivity of the antenna module 1. The ordinate of Fig. 21 indicates the received power [dBm], and the abscissa indicates the azimuth angle $\phi$.

As shown in Fig. 21, in both cases in which the horizontal distances are 4.5 cm and 9 cm, the peak of the received power appears at the azimuth angle of 0°. From the results of Fig. 21, it was confirmed that the directivity of the antenna module 1 had almost no horizontal distance dependence.

Then, the directivity at the time of receiving the terahertz wave of 0.12 THz and at the time of receiving the terahertz wave of 0.3 THz was measured. The horizontal distance between the transmitter and the antenna module 1 is 9 cm. In this case, the received power of the antenna module 1 was measured with the elevation angle $\theta$ and the azimuth angle $\phi$ being changed by 180° in steps of 5° as the reception angle of the antenna module 1.

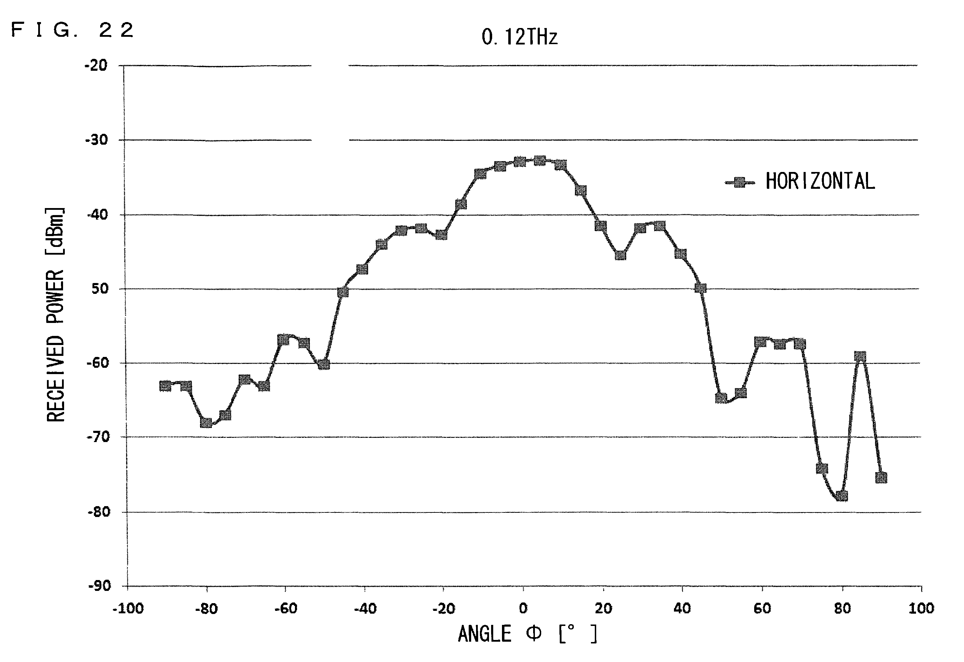

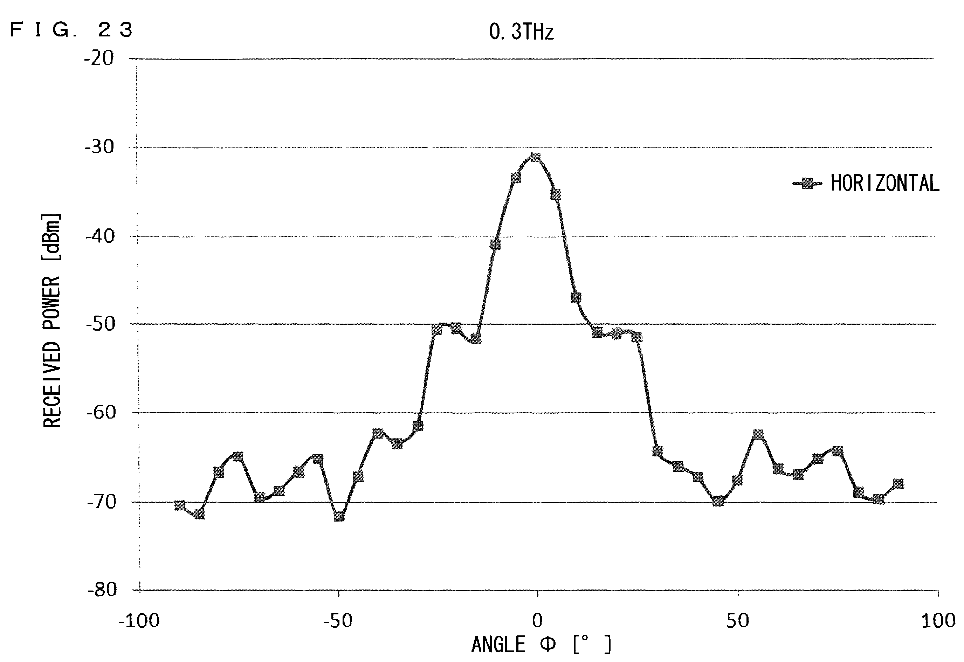

Fig. 22 is a diagram showing the measurement results of the directivity at the time of receiving the terahertz wave of 0.12 THz. Fig. 23 is a diagram showing the measurement results of the directivity at the time of receiving the terahertz wave of 0.3 THz. The ordinates of Figs. 22 and 23 indicate the received power [dBm], and the abscissas indicate the azimuth angle $\phi$. "Horizontal" means the case in which the azimuth angle $\phi$ was changed.

As shown in Fig. 22, at the time of receiving the terahertz wave of 0.12 THz, the peak of the received power appears at the azimuth angle of 0°. Further, as shown in Fig. 23, also at the time of receiving the terahertz wave of 0.3 THz, the peak of the received power appears at the azimuth angle of 0°.

The results of Figs. 22 and 23 shows that the antenna module 1 has the directivity in the central axis direction parallel to the main surface of the dielectric film 10.

Furthermore, the directivity of the antenna module 1 of Fig. 11 was found by the electromagnetic field simulation. In the simulation, the change in antenna gain [dBi] due to the change in elevation angle $\theta$, and the change in antenna gain [dBi] due to the change in azimuth angle $\phi$ were calculated. In this case, the antenna gain [dBi] was calculated with the elevation angle $\theta$ and the azimuth angle $\phi$ being changed by 180° in steps of 1° as the reception angle of the antenna module 1.

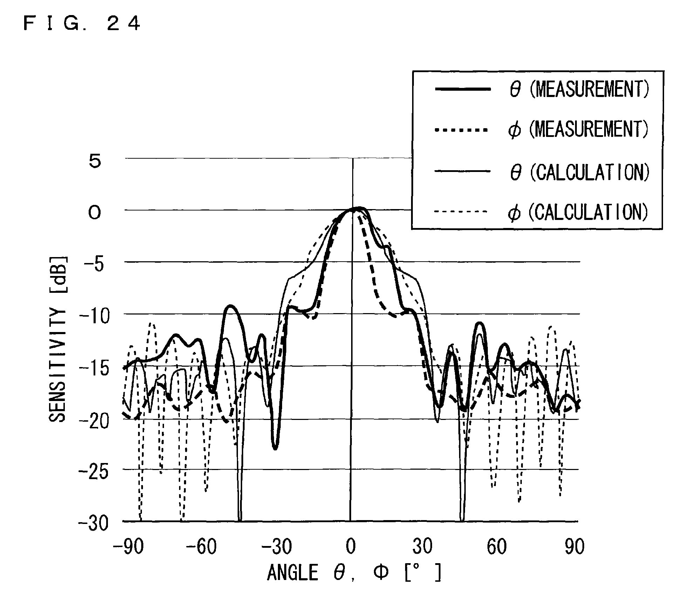

Fig. 24 is a diagram showing the measurement results (see Fig. 23) and the calculation results of the directivity at the time of receiving the terahertz wave of 0.3 THz. The ordinate of Fig. 24 indicates the sensitivity [dB], and the abscissa indicates the azimuth angle $\phi$ or the elevation angle $\theta$.

In Fig. 24, the calculation value of the antenna gain [dBi] and the measurement value of the afore-mentioned received power [dBm] of Fig. 23 are modified such that the peak value is at the sensitivity of 0[dB]. The change in measurement value of the sensitivity due to the change in elevation angle $\theta$ is indicated by the bold line, and the change in measurement value of the sensitivity due to the change in azimuth angle $\phi$ is indicated by the bold dotted line. Further, the change in calculated value of the sensitivity due to the change in elevation angle θ is indicated by the thin line, and the change in calculation value of the sensitivity due to the change in azimuth angle φ is indicated by the thin dotted line.

From Fig. 24, it is found that the measurement results by the experiment and the calculation results by the simulation show substantially the same tendency regarding the directivity of the antenna module 1. Thus, validity of design of the antenna module 1 was confirmed.

(f) Change in Directivity Due to Bend of Antenna Module

Next, the change in directivity when the antenna module 1 is not bent and when the antenna module is bent were found by the electromagnetic field simulation.

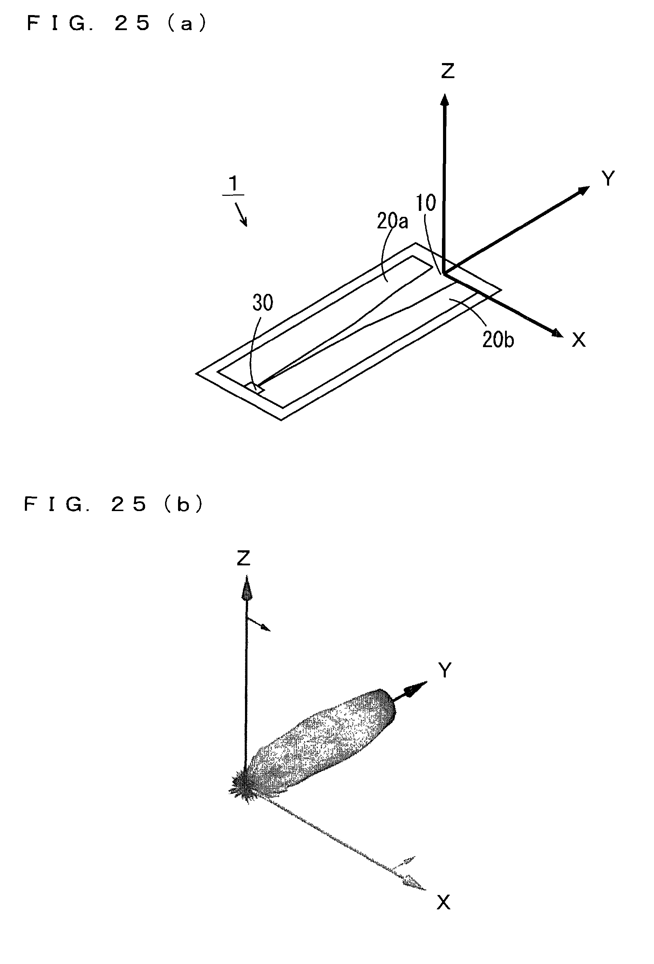

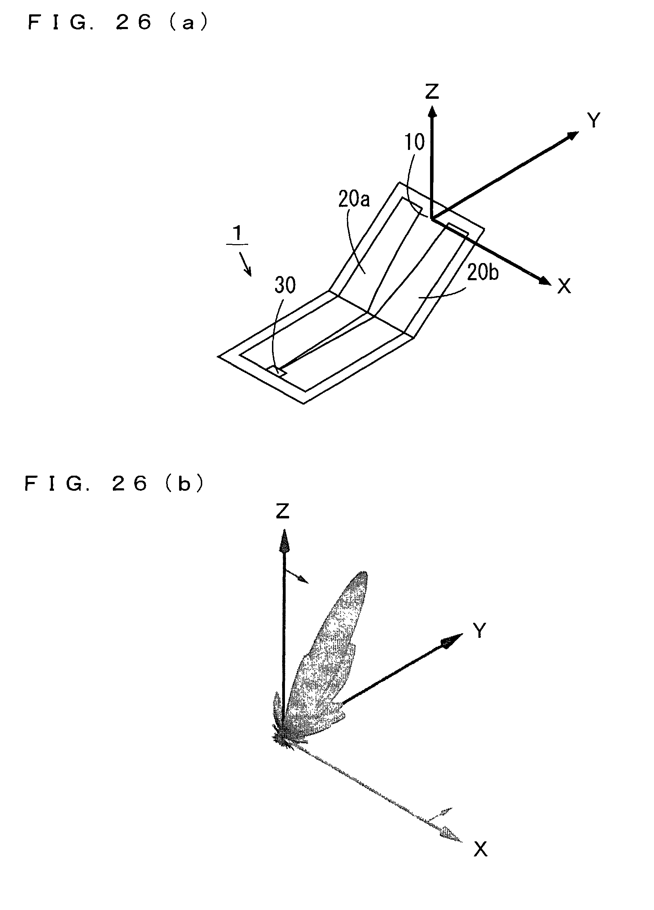

Figs. 25(a) and 25(b) are diagrams showing the results of the three-dimensional electromagnetic field simulation obtained when the antenna module 1 is not bent. Figs. 26(a) and 26(b) are diagrams showing the results of the three-dimensional electromagnetic field simulation obtained when the antenna module 1 is bent. Figs. 25(a) and 26(a) are diagrams for explaining the definition of the directions of the antenna module 1, and Figs. 25(b) and 26(b) are diagrams indicating the radiation characteristics (directivity) of the antenna module 1.

The central axis direction of the antenna module 1 is referred to as the Y direction, a direction parallel to the main surface of the dielectric film 10 and orthogonal to the Y direction is referred to as the X direction, and a direction vertical to the main surface of the dielectric film 10 is referred to as the Z direction.

When the antenna module 1 is not bent as shown in Fig. 25(a), the electromagnetic wave is radiated in the Y direction as shown in Fig. 25(b).

When the antennal module 1 is bent obliquely upward by 45°along an axis parallel to the X direction as shown in Fig. 26(a), the electromagnetic wave is radiated obliquely upward by 45° with respect to the Y direction in the YZ plane.

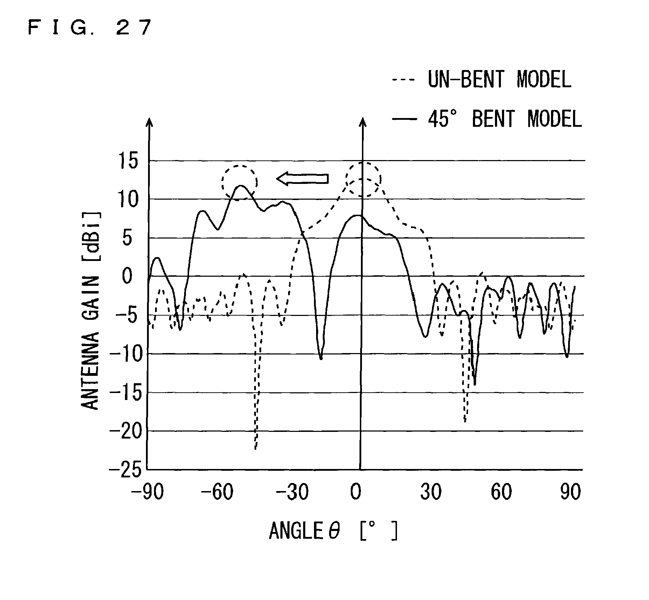

Fig. 27 is a diagram showing the calculation results of the antenna gain obtained when the antenna module 1 is not bent and when the antenna module 1 is bent. The ordinate of Fig. 27 indicates the antenna gain [dBi], and the abscissa indicates the elevation angle θ. The calculation results of the antenna gain of the antenna module 1 that is not bent (un-bent model) is indicated by the dotted line, and the calculation results of the antenna gain of the antenna module 1 that is bent (45° bent model) is indicated by the solid line.

As shown in Fig. 27, when the antenna module 1 is not bent, the position of the peak of the antenna gain is at 0°, and when the antenna module 1 is bent, the position of the peak of the antenna gain is shifted to about 45°.

From these results, it is found that the direction of the directivity of the antenna module 1 can be arbitrarily set by bending the antenna module 1.

(1-7) Effects of First Embodiment

Because the dielectric film 10 is formed of resin in the antenna module 1 according to the present embodiment, the effective relative dielectric constant of the tapered slot S is low. Thus, the electromagnetic wave radiated from the electrodes 20a, 20b or the electromagnetic wave received by the electrodes 20a, 20b are not attracted to the dielectric film 10. Therefore, the antenna module 1 has the directivity in a specific direction. In this case, because the dielectric film 10 is flexible, it is possible to obtain the directivity of a desired direction by bending the dielectric film 10.

Further, because the effective relative dielectric constant of the tapered slot S is low, the transmission loss of the electromagnetic wave is reduced. Thus, the transmission speed and the transmission distance can be improved.

Further, because the dielectric film 10 is flexible, the antenna module 1 is difficult to be damaged even in a case in which the thickness of the dielectric film 10 is small.

(2) Second Embodiment

(2-1) Configuration of Antenna Module

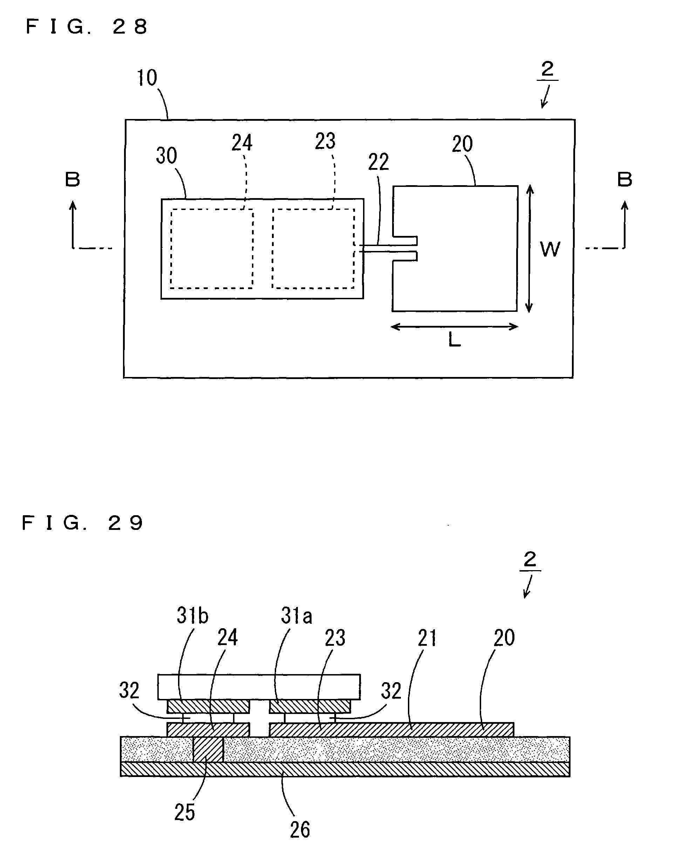

Fig. 28 is a schematic plan view of the antenna module according to the second embodiment of the present invention. Fig. 29 is a schematic cross sectional view taken along the line B-B of the antenna module of Fig. 28.

In Figs. 28 and 29, the antenna module 2 is constituted by a dielectric film 10, a rectangular electrode 20, a wiring 22, a pair of rectangular pads 23, 24, a grounding conductive layer 26 and a semiconductor device 30.

The electrode 20, the wiring 22 and the pads 23, 24 are formed on the main surface of the dielectric film 10. The electrode 20 is connected to the pad 23 through the wiring 22. The pads 23, 24 are arranged to be spaced apart from each other.

A through hole is formed at a portion of the dielectric film 10 under the pad 24, and a conductive connection conductor 25 is filled in the through hole. The grounding conductive layer 26 is formed on the back surface of the dielectric film 10. The pad 24 and the grounding conductive layer 26 are electrically connected by the connection conductor in the through hole. The electrode 20 and the grounding conductive layer 26 constitute a patch antenna.

The dielectric film 10, the electrode 20, the wiring 22, the pads 23, 24 and the grounding conductive layer 26 are formed of a flexible printed circuit board. In this case, the electrode 20, the wiring 22 and the pads 23, 24 are formed on the dielectric film 10 using the subtractive method, the additive method or the semi-additive method, or by patterning the conductive material or the like.

As shown in Fig. 29, the semiconductor device 30 is mounted on the pads 23, 24 by the flip chip mounting method. The terminals 31a, 31b of the semiconductor device 30 are bonded to the pads 23, 24 using Au stud bumps 32, respectively. The semiconductor device 30 may be mounted on the dielectric film 10 using the wire bonding mounting method.

The material, the thickness and the relative dielectric constant of the dielectric film 10 in the present embodiment are similar to the material, the thickness and the relative dielectric constant of the dielectric film 10 in the first embodiment. Further, the material for the electrode 20, the wiring 22 and the pads 23, 24 in the present embodiment is similar to the material for the electrode 20a, 20b in the first embodiment. The grounding conductive layer 26 may be formed of a conductive material such as metal, an alloy or the like, and may have a single layer structure, or may have a laminate structure of a plurality of layers.

One or plurality of semiconductor devices similar to the first embodiment can be used as the semiconductor device 30. In the present embodiment, the semiconductor device 30 is a Schottky-barrier diode.

(2-2) Simulation of Antenna Module

A radiation direction of the electromagnetic wave from the antenna module 2 of Figs. 28 and 29 and a reflection loss S11 in the antenna module 2 were found by the electromagnetic field simulation.

In the antenna module 2 used in the present simulation, the dielectric film 10 is made of polyimide, and the electrode 20, the wiring 22, the pads 23, 24 and the grounding conductive layer 26 are made of copper. The thickness of the dielectric film is 25 $\mu$m, and the thickness of the electrode 20, the wiring 22, the pads 23, 24 and the grounding conductive layer 26 is 16 $\mu$m.

When the width W of the electrode 20 and the length L of the electrode 20 are the same, the width W and the length L of the electrode 20 are expressed in the following formula using a wavelength $\lambda$ of the electromagnetic wave transmitted or received by the antenna module 2 and the effective relative dielectric constant $\varepsilon_{ref}$ of the surroundings of the electrode 20.

$$W = L = \lambda \diagup (2\sqrt{\varepsilon_{ref}})$$

The effective relative dielectric constant $\varepsilon_{ref}$ of the surroundings of the electrode 20 is presumed to be 2.6. In a case in which the electromagnetic wave of 0.3 THz is transmitted or received, the width W and the length L of the electrode 20 are calculated to be 310 $\mu$m.

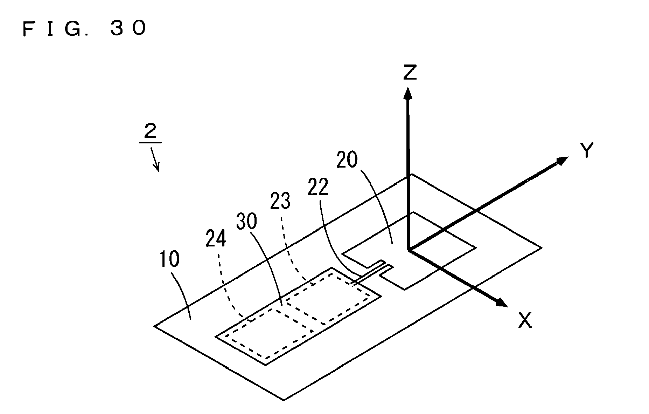

Fig. 30 is a diagram for explaining the definition of the directions of the antenna module 2. A direction along the wiring 22 of the antenna module 2 is referred to as the Y direction, and a direction parallel to the main surface of the dielectric film 10 and orthogonal to the Y direction is referred to as the X direction and a direction vertical to the main surface of the dielectric film 10 is referred to as the Z direction.

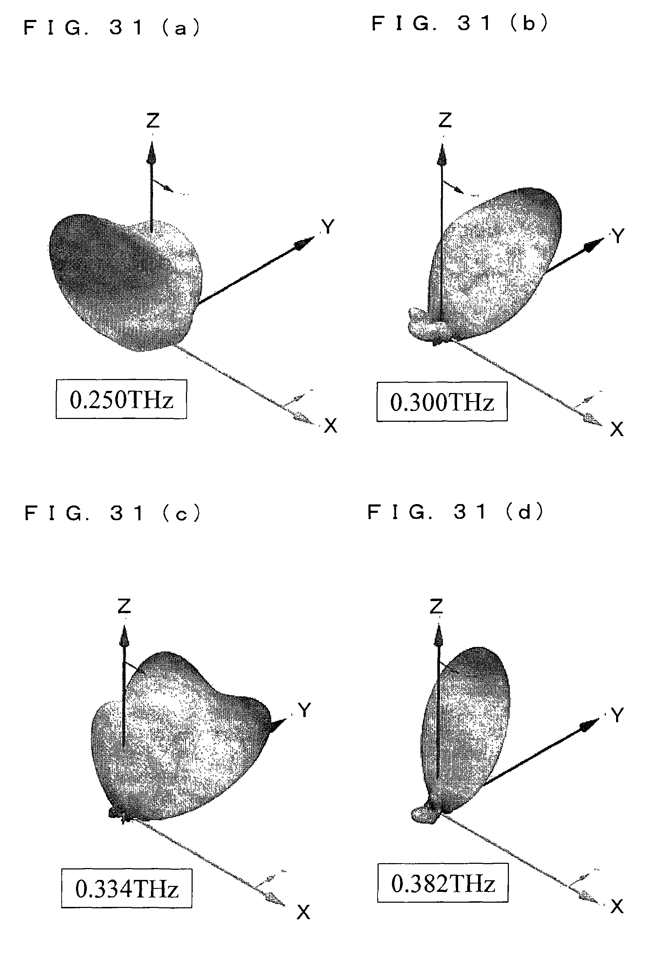

Figs. 31 (a) to 31 (d) are diagrams showing the results of the three-dimensional electromagnetic field simulation of the antennal module 1 of Fig. 28. Figs. 31 (a), 31 (b), 31 (c) and 31 (d) show the radiation characteristics (directivity) at 0.250 THz, 0.300 THz, 0.334 THz and 0.382 THz, respectively. As shown in Figs. 31 (a) to 31 (d), the radiation characteristics differ depending on the frequencies.

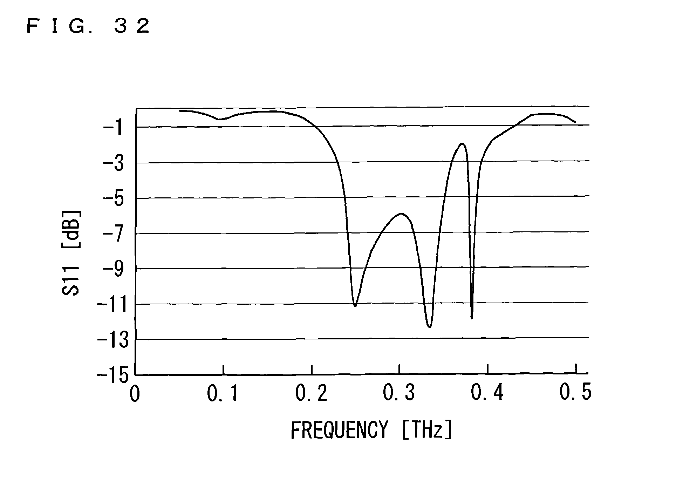

Fig. 32 is a diagram showing the calculation results of the reflection loss S11 of the antenna module 2 of Fig. 28. The ordinate of Fig. 32 indicates the reflection loss S11 [dB], and the abscissa indicates the frequency [THz].

As shown in Fig. 32, the reflection loss is low at a plurality of specific frequencies in the terahertz band.

From the above results, it is found that the antenna module 2 of Figs. 28 and 29 enables the electromagnetic wave having a specific frequency in the terahertz band to be radiated in a specific direction.

(2-3) Modified Example of Antenna Module

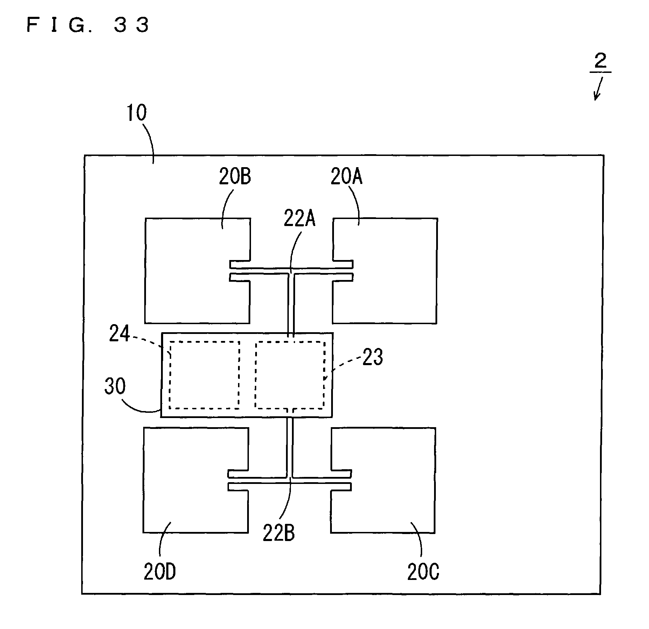

Fig. 33 is a schematic plan view showing a modified example of the antenna module 2 according to the present embodiment.

In the example of Fig. 33, four rectangular electrodes 20A, 20B, 20C, 20D are formed on the main surface of a dielectric film 10. The electrodes 20A, 20B are connected to a pad 23 through a wiring 22A. The electrodes 20C, 20D are connected to a pad 23 through a wiring 22B. A semiconductor device 30 is mounted on the pads 23, 24.

(2-4) Simulation of Modified Example

The radiation direction of the electromagnetic wave from the antenna module 2 of Fig. 33 and the reflection loss S11 were found by the electromagnetic field simulation.

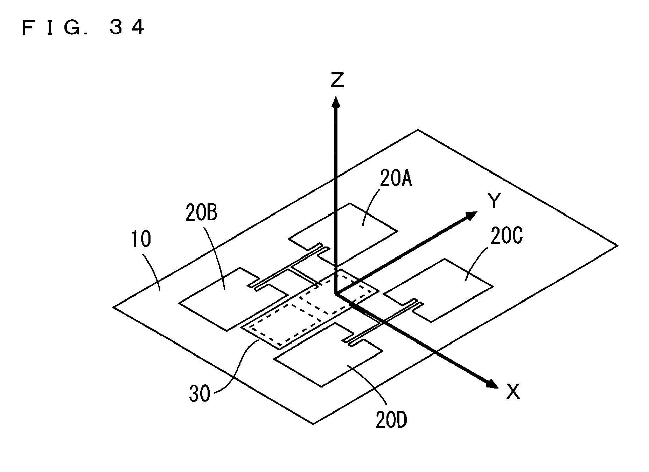

Fig. 34 is a diagram for explaining the definition of the directions of the antenna module 2. A direction in which the pad 24 and the pad 23 of the antenna module 2 are aligned is referred to as the Y direction, and a direction parallel to the main surface of the dielectric film 10 and orthogonal to the Y direction is referred to as the X direction and a direction vertical to the main surface of the dielectric film 10 is referred to as the Z direction.

The conditions of the present simulation are similar to the conditions of the simulation of Figs. 31 and 32 except that the antenna module 2 has the four electrodes 20A, 20B, 20C, 20D.

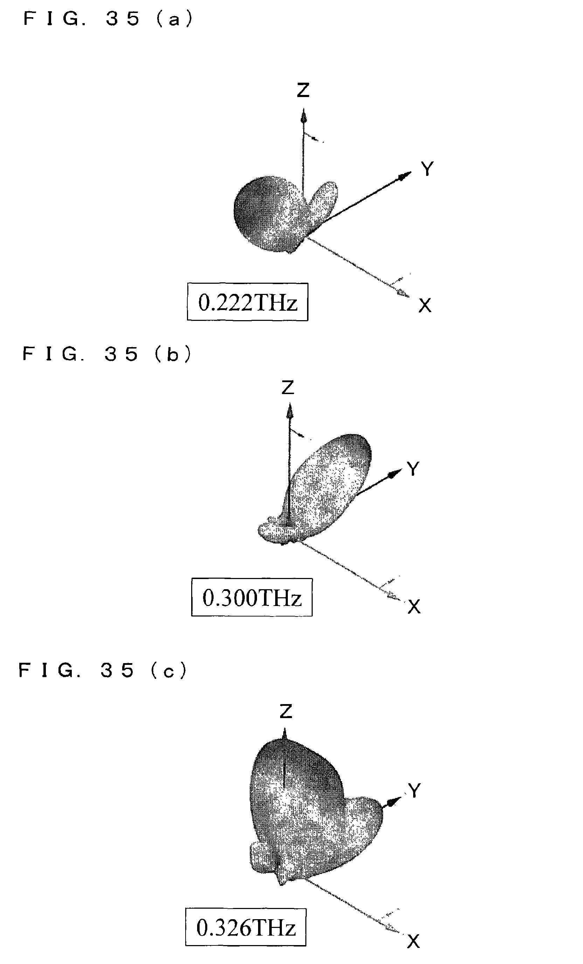

Figs. 35(a) to 35(c) are diagrams showing the results of the three-dimensional electromagnetic field simulation of the antenna module 2 of Fig. 33. Figs. 35(a), 35(b) and 35(c) show the radiation characteristics (directivity) at 0.222 THz, 0.300 THz and 0.326 THz, respectively. As shown in Figs. 35(a) to 35(c), the radiation characteristics differ depending on the frequencies.

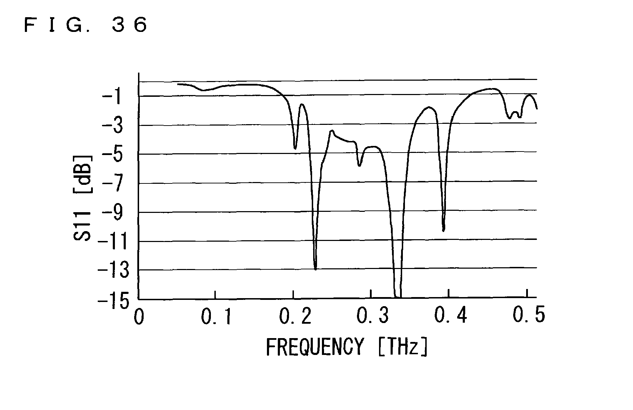

Fig. 36 is a diagram showing the calculation results of the reflection loss S11 of the antenna module 2 of Fig. 33. The ordinate of Fig. 36 indicates the reflection loss S11 [dB], and the abscissa indicates the frequency [THz]. As shown in Fig. 36, the reflection loss is low at a plurality of specific frequencies in the terahertz band.

From the above results, it is found that the antenna module 2 of Fig. 33 enables the electromagnetic wave having a specific frequency in the terahertz band to be radiated in a specific direction.

Further, from the results of simulation of Figs. 31(a) to 31(d), 32, 35(a) to 35(c) and 36, it is found that the directivity of a desired direction regarding the electromagnetic wave having a desired frequency in the terahertz band can be obtained by adjusting the number of electrodes that constitute a patch antenna.

(3) Third Embodiment

(3-1) Configuration of Antenna Module

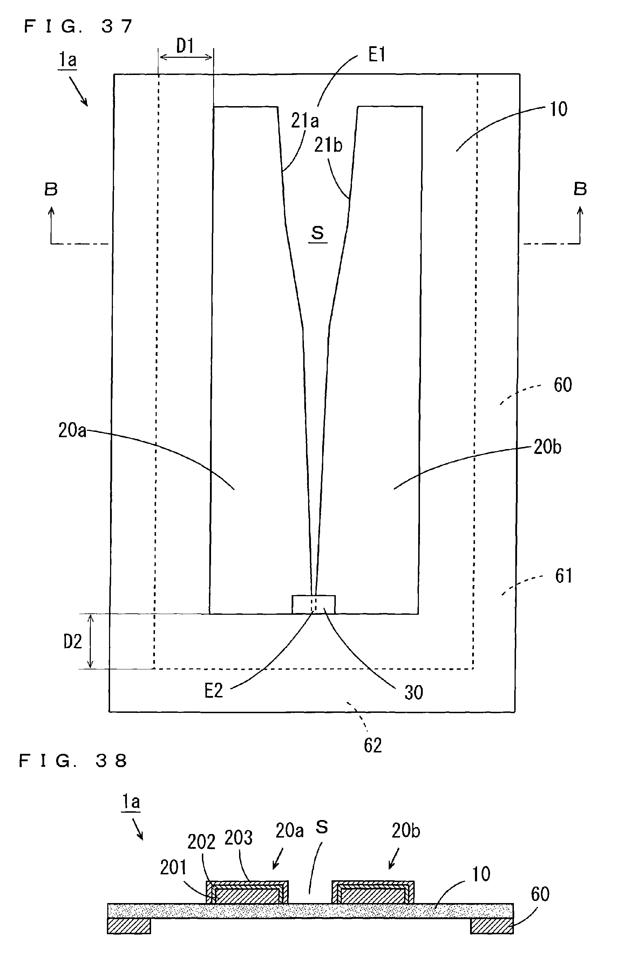

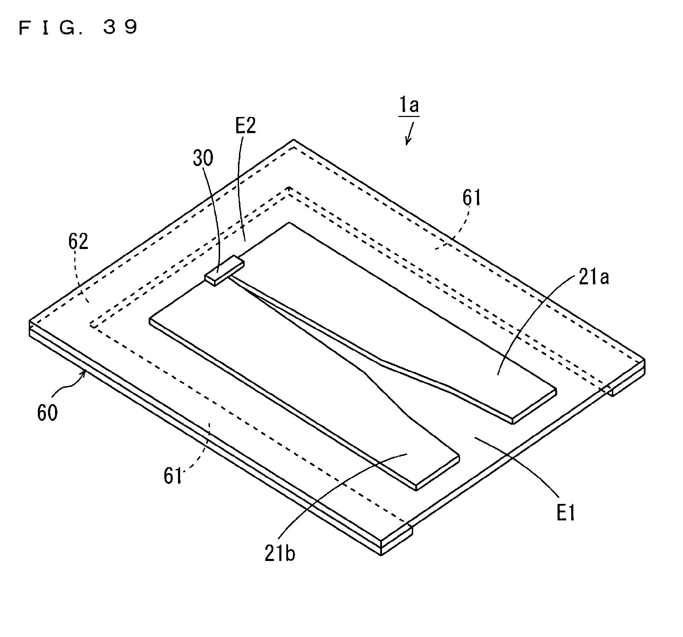

Fig. 37 is a schematic plan view of the antenna module according to the third embodiment of the present invention. Fig. 38 is a schematic cross sectional view taken along the line B-B of the antenna module of Fig. 37. Fig. 39 is a schematic perspective view of the antenna module of Fig. 37.

The configuration of the antenna module 1a of Figs. 37 to 39 is different from the configuration of the antenna module 1 of Figs. 1 and 2 in the following points.

The antenna module 1a of Figs. 37 to 39 further includes a support body 60 formed on the back surface of the dielectric film 10. The support body 60 is formed of a material having a shape-retaining property. In the present embodiment, the support body 60 is a metal layer made of stainless. The support body 60 may be formed of iron, aluminum or another metal layer such as copper.

The support body 60 is formed in a region except for a region right under the electrodes 20a, 20b. In this case, the support body 60 is arranged in a region that does not overlap with the electrodes 20a, 20b. Thus, a relative dielectric constant in a region below the dielectric film 10 directly under the electrodes 20a 20b is the relative dielectric constant of air (about 1).

In the present embodiment, the support body 60 is constituted by a pair of first supporters 61 that extends in parallel to the outer lateral sides of the electrodes 20a, 20b and a second supporter 62 that extends in parallel to the mount end E2 of the set of the electrodes 20a, 20b. The first supporters 61 are arranged to be spaced apart a distance D1 from the outer lateral sides of the electrodes 20a, 20b, and the second supporter 62 is arranged to be spaced apart a distance D2 from the mount end E2 of the set of the electrodes 20a, 20b.

From the below-mentioned simulation results, it is found that the distance D1 between each of the electrodes 20a, 20b and each of the first supporters 61 is preferably not less than 0.1 mm. In this case, the antenna gain is not influenced by the support body 60 as mentioned below.

While the thickness of the support body 60 is not limited to a specific range, the thickness of the support body 60 is preferably set such that the sufficient shape-retaining property of the antenna module 1a is ensured in consideration of the area of the antennal module 1a, the shape of the electrodes 20a, 20b, the shape of the support body 60, the material for the support body 60 and the like. In the present embodiment, SUS306 is used as the material for the support body 60, for example, and the thickness of the support body 60 is set to not less than 30 μm and not more than 50 μm, for example.

(3-2) Manufacturing Method of Antenna Module 1a

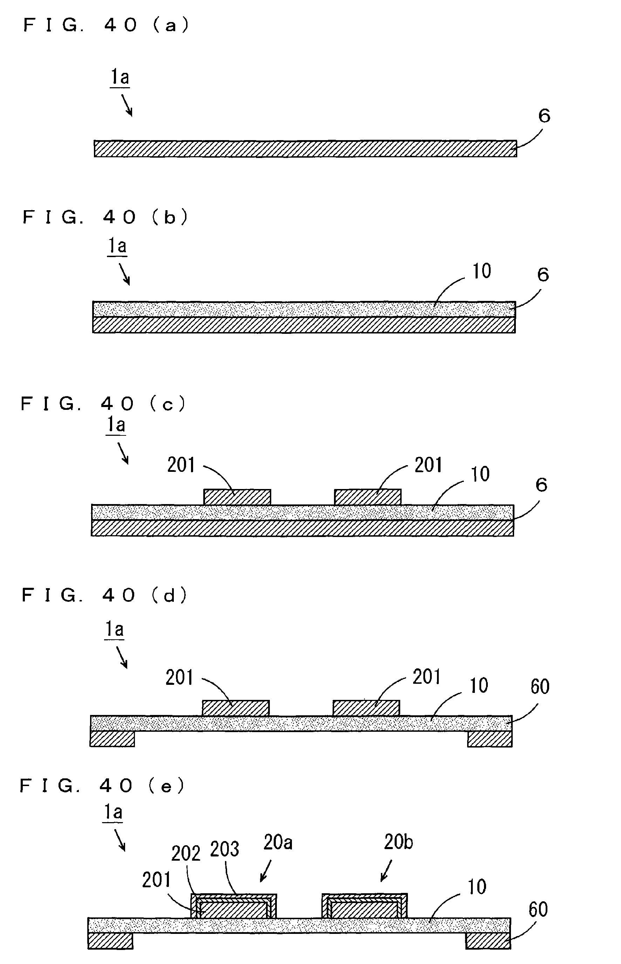

Figs. 40(a) to 40(e) are schematic sectional views for use in illustrating steps in the process of manufacturing the antenna module 1a of Fig. 37.

As shown in Fig. 40(a), a metal base material 6 made of SUS306 having a thickness of 50 $\mu$m is prepared, for example. Next, as shown in Fig. 40(b), a polyimide precursor is applied to the upper surface of the metal base material 6 and heating processing is performed, whereby the dielectric film 10 made of polyimide is formed on the metal base material 6.

Next, as shown in Fig. 40(c), a pair of copper layers 201 is formed on the dielectric film 10 using the semi-additive method or the additive method. Thereafter, a photoresist is formed on the lower surface of the metal base material 6, and wet etching is performed on a portion of the metal base material 6 below the pair of copper layers 201 using an iron chloride solution, for example, whereby the support body 60 is formed as shown in Fig. 40(d).

Furthermore, surface processing appropriate for the mounting method of the semiconductor device (see Figs. 37 to 39) is performed on the copper layer 201. As shown in Fig. 40(e), for example, a nickel layer 202 and a gold layer 203 are sequentially formed on each surface of the pair of copper layers 201. Thus, the pair of electrodes 20a, 20b is formed.

(3-3) Influence of Support Body on Directivity and Antenna Gain

Presence/absence of influence of the support body 60 on the directivity and the antenna gain of the antenna module 1a of Fig. 37 was considered by the electromagnetic field simulation. In the following electromagnetic field simulation, the material for the support body 60 was considered as stainless.

First, as for the antenna module 1a of Fig. 37, the change in antenna gain was calculated while the distance D1 (hereinafter referred to as a support body-electrode distance D1) between the support body 60 and the electrodes 20a, 20b was changed from 0 mm to 3.0 mm.

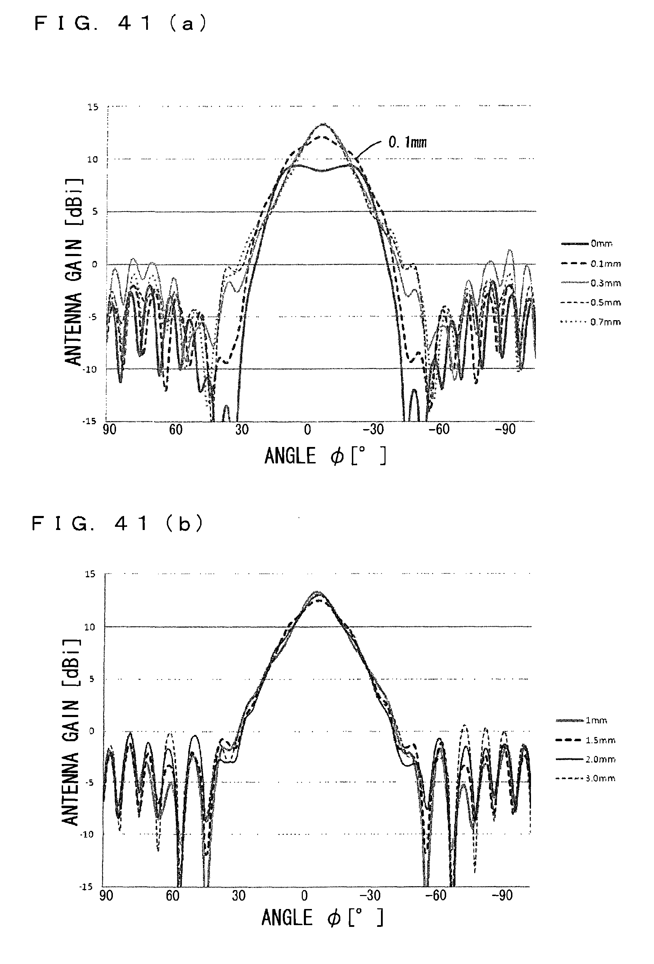

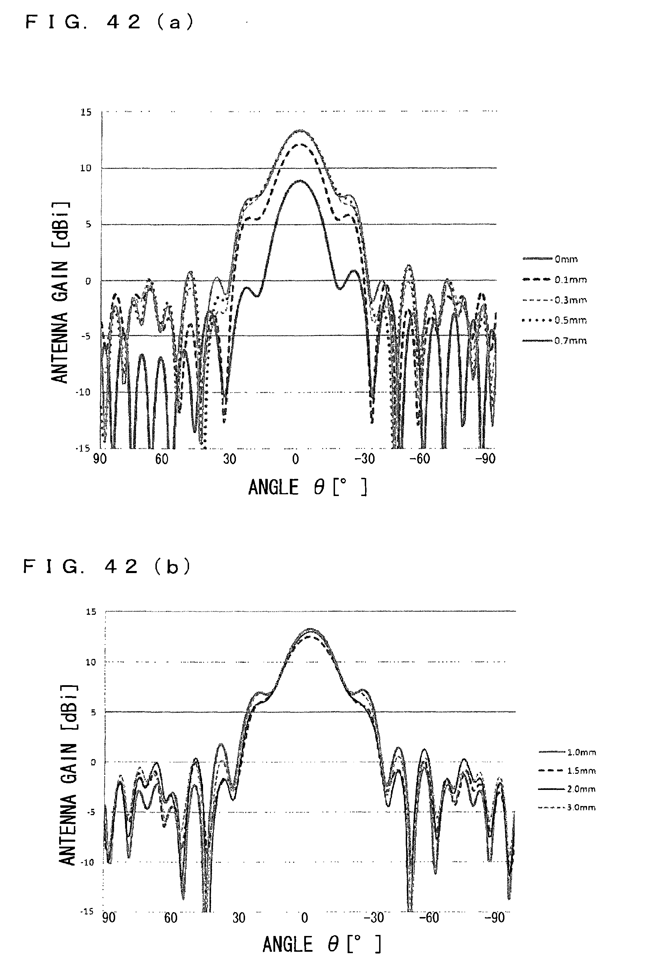

Figs. 41(a), 41(b), 42(a) and 42(b) are diagrams showing the calculation results of the change in antenna gain obtained when the support body-electrode distance D1 is changed. The ordinates of Figs. 41 (a) and 41 (b) indicate the antenna gain [dBi], and the abscissas indicate an azimuth angle $\phi$. The ordinates of Figs. 42(a) and 41(b) indicate the antenna gain [dBi], and the abscissas indicate an elevation angle $\theta$. The definitions of the azimuth angle $\phi$ and the elevation angle $\theta$ are as shown in Fig. 20. The wavelength of the electromagnetic wave is 0.3 THz.

Figs. 41 (a) and 42(a) show the antenna gain obtained when the support body-electrode distance D1 is 0 mm, 0.1 mm, 0.3 mm, 0.5 mm and 0.7 mm, and Figs. 41 (b) and 42(b) show the antenna gain obtained when the support body-electrode distance D1 is 1 mm, 1.5 mm, 2.0 mm and 3.0 mm.

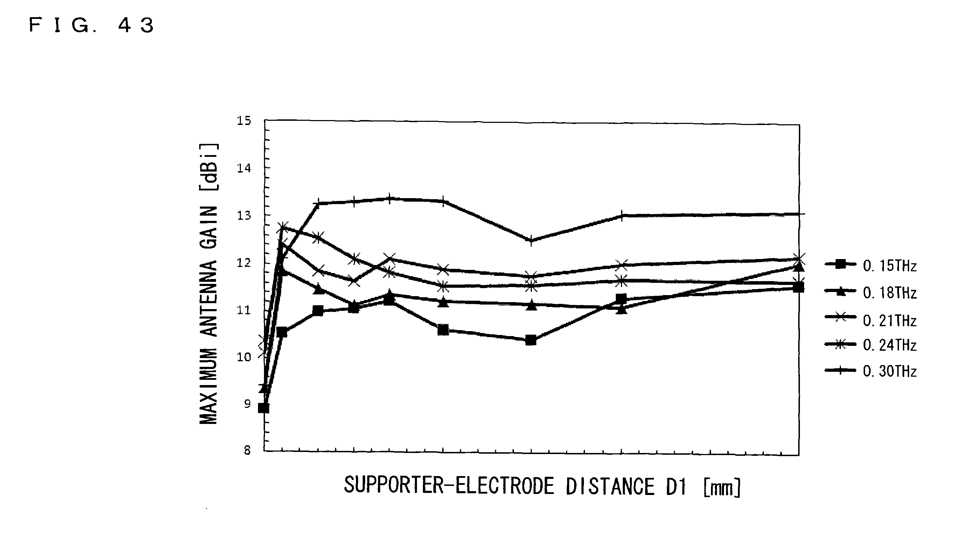

Fig. 43 is a diagram showing the calculation results of the maximum antenna gain obtained when the frequency of the electromagnetic wave is changed from 0.15 THz to 0.30 THz. The ordinate of Fig. 43 indicates the maximum antenna gain [dBi], and the abscissa indicates the distance D1 between support body- electrode.

As shown in Figs. 41 (a), 41 (b), 42(a) and 42(b), when the support body-electrode distance D1 is not less than 0.1 mm, the antenna gain has a peak at a position in which the azimuth angle $\phi$ and the elevation angle $\theta$ are 0°. Further, when the support body-electrode distance D1 is not less than 0.1 mm, the maximum antenna gain is large as compared to a case in which the support body-electrode distance D1 is 0.

As shown in Fig. 43, as for the electromagnetic waves of the frequencies at 0.15 THz, 0.18 THz, 0.21 THz, 0.24 THz and 0.30 THz, when the support body-electrode distance D1 is not less than 0.1 mm, the maximum antenna gain is large as compared to a case in which the support body-electrode distance D1 is 0.

Those results show that when the support body-electrode distance D1 is not less than 0.1 mm, the directivity of the antenna gain is substantially equal and the transmission loss is small. Therefore, the support body-electrode distance D1 is preferably not less than 0.1 mm.

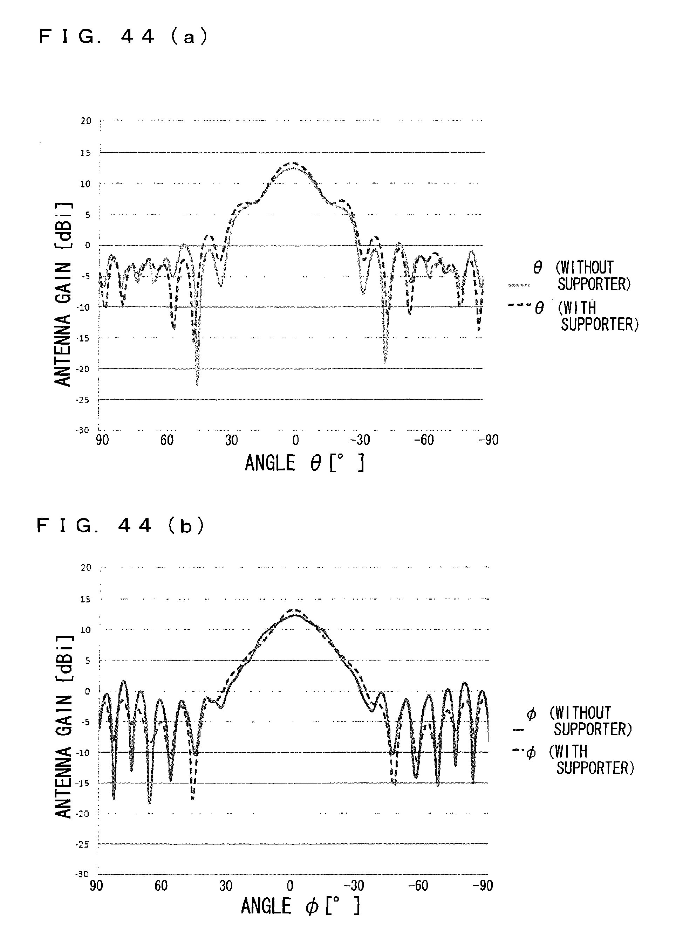

Next, difference in antenna gain due to presence/absence of the support body 60 in the antenna module 1a of Fig. 37 was calculated. Figs. 44(a) and 44(b) are diagrams showing the calculation results of the antenna gain obtained when the antenna module 1a has the support body 60 and when the antenna module 1a does not have the support body 60. The ordinate of Fig. 44(a) indicates the antenna gain [dBi], and the abscissa indicates the azimuth angle $\phi$. The ordinate of Fig. 44(b) indicates the antenna gain [dBi], and the abscissa indicates the elevation angle $\theta$. The support body-electrode distance D1 is 1.0 mm in the antenna module 1a having the support body 60

As shown in Figs. 44(a) and 44(b), there is no significant difference in antenna gain between a case in which the antenna module 1a has the support body 60 and a case in which the antenna module 1a does not have the support body 60.

From those results, it is found that the support body 60 hardly influences the antenna gain when the support body-electrode distance D1 is not less than 0.1 mm.

(3-4) Effects of Support Body of Antenna Module

In the antenna module 1a according to the present embodiment, even when the thickness of the dielectric film 10 is small, the shape-retaining property of the antenna module 1a is ensured by the support body 60. Thus, the transmission direction and the reception direction of the electromagnetic wave can be fixed. Further, handleability of the antenna module 1a is improved.

In this case, because the support body 60 is provided in a region except for a region under the electrodes 20a, 20b, the change in directivity and the transmission loss of the electromagnetic wave due to the support body 60 can be suppressed. In particular, when the support body-electrode distance D1 is set to not less than 0.1 mm, the change in directivity and the transmission loss of the electromagnetic wave can be prevented from occurring.

(4) Other Embodiments

While the electrodes 20a, 20b, 20, 20A, 20B, 20C, 20D are provided on the main surface of the dielectric film 10 in the above-mentioned embodiment, the present invention is not limited to this. The electrodes may be provided on the back surface of the dielectric film 10, or a plurality of electrodes may be provided on the main surface and the back surface of the dielectric film 10.

While the semiconductor device 30 is mounted on the main surface of the dielectric film 10 in the above-mentioned embodiment, the present invention is not limited to this. The semiconductor device 30 may be mounted on the back surface of the dielectric film 10, or a plurality of semiconductor devices 30 may be mounted on the main surface and the back surface of the dielectric film 10.

For example, the electrodes may be formed on the main surface of the dielectric film 10, and the semiconductor device 30 may be mounted on the back surface of the dielectric film 10.

While the antenna module 1 that includes the tapers slot antenna and the antenna module 2 that includes the patch antenna are described in the above-mentioned embodiment, the present invention is not limited to these. The present invention is applicable to another planar antenna such as a parallel slot antenna, a notch antenna or a microstrip antenna.

While the support body 60 is provided at the antenna module of Fig. 1 that includes the tapered slot antenna in the third embodiment, the present invention is not limited to this. The support body 60 may be provided on the lower surface of an antenna module that includes a patch antenna or another planar antenna.

While the support body 60 in the third embodiment is formed of metal, the present invention is not limited to this. The support body 60 may be formed of resin having a higher shape-retaining property than the dielectric film 10, for example.

INDUSTRIAL APPLICABILITY

The present invention can be utilized for the transmission of an electromagnetic wave having a frequency in the terahertz band.

While preferred embodiments of the present invention have been described above, it is to be understood that variations and modifications will be apparent to those skilled in the art without departing the scope and spirit of the present invention. The scope of the present invention, therefore, is to be determined solely by the following claims.

**Claims**

1. An antenna module comprising:

   a dielectric film that has first and second surfaces and is made of resin;
   an electrode formed on at least one of the first and second surfaces of the dielectric film to be capable of receiving and transmitting an electromagnetic wave in a terahertz band; and
   a semiconductor device mounted on at least one of the first and second surfaces of the dielectric film to be electrically connected to the electrode and operable in the terahertz band.

2. The antenna module according to claim 1, wherein
   the resin includes a porous resin.

3. The antenna module according to claim 1 or 2, wherein
   the dielectric film has a thickness of not less than 1 $\mu$m and not more than 1000 $\mu$m.

**4.** The antenna module according to any one of claims 1 to 3, wherein
the dielectric film has a relative dielectric constant of not more than 7.0 in the terahertz band.

**5.** The antenna module according to any one of claims 1 to 4, wherein
the electrode includes first and second conductive layers that constitute a tapered slot antenna having an opening, and
the opening has a width that continuously or gradually decreases from one end to another end of a set of the first and second conductive layers.

**6.** The antenna module according to claim 5, wherein
the width of the opening at the one end of each of the first and second conductive layers is set such that one portion of the tapered slot has a width that enables transmission or receipt of the electromagnetic wave in the terahertz band.

**7.** The antenna module according to any one of claims 1 to 4, wherein
the electrode includes a conductive layer formed on the first surface of the dielectric film and a grounding conductive layer formed on the second surface of the dielectric film, and the conductive layer and the grounding conductive layer constitute a patch antenna.

**8.** The antenna module according to any one of claims 1 to 7, wherein
the electrode is formed on the first surface of the dielectric film, and
the antenna module further comprising a support body formed on the second surface of the dielectric film.

**9.** The antenna module according to claim 8, wherein
the support body is formed in a region that does not overlap with the electrode on the second surface.

F I G. 1

F I G. 2

F I G. 3

F I G. 4

F I G. 5

F I G. 6

F I G. 7

F I G. 8

F I G. 9

F I G. 1 0

F I G.  1 1

1

FIG. 12

FIG. 13

FIG. 14

100

EP 2 731 195 A1

```
105
┌──────────────────┐          106        107        ┌──────────────────┐   1
│ TERAHERTZ WAVE   │                                │  ANTENNA MODULE  │
│   GENERATOR      │                                │                  │
└──────────────────┘          f 0                   └──────────────────┘

104                                                 108
┌──────────────────┐                                ┌──────────────────┐
│     OPTICAL      │                                │    BASEBAND      │
│    AMPLIFIER     │                                │   AMPLIFIER      │
└──────────────────┘                                └──────────────────┘

103                           102                   109
┌──────────────────┐   ┌──────────────────┐         ┌──────────────────┐
│     OPTICAL      │ ← │  PULSE PATTERN   │         │    LIMITING      │
│    MODULATOR     │   │   GENERATOR      │         │   AMPLIFIER      │
└──────────────────┘   └──────────────────┘         └──────────────────┘

                       101                   110                   111
                ┌──────────────────────┐  ┌──────────────────┐  ┌──────────────────┐
                │ DIFFERENCE-FREQUENCY │  │   OSCILLOSCOPE   │  │  ERROR DETECTOR  │
                │    LASER SOURCE      │  │                  │  │                  │
                └──────────────────────┘  └──────────────────┘  └──────────────────┘
```

EP 2 731 195 A1

F I G. 1 6

TRANSMISSION POWER: 20 μW

0. 12THz

F I G. 1 7

TANSMISSION POWER: 80 μW

0. 3THz

FIG. 18

FIG. 19

FIG. 20

F I G. 2 1

0.12THz

F I G. 2 2

0.12THz

HORIZONTAL

RECEIVED POWER [dBm]

ANGLE φ [°]

F I G. 2 3

0.3THz

RECEIVED POWER [dBm]

ANGLE Φ [°]

■ HORIZONTAL

EP 2 731 195 A1

FIG. 24

FIG. 25 (a)

FIG. 25 (b)

FIG. 26 (a)

FIG. 26 (b)

FIG. 27

F I G. 2 8

F I G. 2 9

F I G. 3 0

F I G. 3 1 (a)

Z

Y

X

0.250THz

F I G. 3 1 (b)

Z

Y

X

0.300THz

F I G. 3 1 (c)

Z

Y

X

0.334THz

F I G. 3 1 (d)

Z

Y

X

0.382THz

FIG. 32

FIG. 33

F I G. 3 4

F I G. 3 5 (a)

0.222THz

F I G. 3 5 (b)

0.300THz

F I G. 3 5 (c)

0.326THz

F I G. 3 6

F I G. 3 7

1a

D1

E1

21a

21b

B

S

B

10

60

20a

20b

61

D2

E2

30

62

F I G. 3 8

1a

202 203 20a S 20b

201 10 60

F I G .  3 9

FIG. 40 (a)

FIG. 40 (b)

FIG. 40 (c)

FIG. 40 (d)

FIG. 40 (e)

FIG. 41 (a)

FIG. 41 (b)

FIG. 42 (a)

FIG. 42 (b)

EP 2 731 195 A1

FIG. 44 (a)

FIG. 44 (b)

**EUROPEAN SEARCH REPORT**

Application Number

EP 13 18 9871

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ACHARYA P R ET AL: "TAPERED SLOTLINE ANTENNAS AT 802 GHZ", IEEE TRANSACTIONS ON MICROWAVE THEORY AND TECHNIQUES, IEEE SERVICE CENTER, PISCATAWAY, NJ, US, vol. 41, no. 10, 1 October 1993 (1993-10-01), pages 1715-1719, XP000414468, ISSN: 0018-9480, DOI: 10.1109/22.247916 * Sections III, IV; figure 3 * | 1-6,8,9 | INV. H01Q3/01 H01Q13/08 |
| X | EP 2 219 266 A1 (HAMAMATSU PHOTONICS KK [JP]) 18 August 2010 (2010-08-18) * paragraph [0022] - paragraph [0027]; figure 4 * | 1,5-8 | |
| X,D | US 2010/026401 A1 (MUKAI TOSHIKAZU [JP] ET AL) 4 February 2010 (2010-02-04) * paragraph [0078] - paragraph [0100]; figure 3 * | 1-3,5,6 | |
| X | FR 2 908 931 A1 (CENTRE NAT RECH SCIENT [FR]) 23 May 2008 (2008-05-23) * figures 1, 4, 7F * | 1 | TECHNICAL FIELDS SEARCHED (IPC) H01Q |
| A | | 7 | |

The present search report has been drawn up for all claims

| Place of search | Date of completion of the search | Examiner |
|---|---|---|
| The Hague | 28 March 2014 | Hueso González, J |

## ANNEX TO THE EUROPEAN SEARCH REPORT
## ON EUROPEAN PATENT APPLICATION NO.

EP 13 18 9871

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2014

| Patent document cited in search report | | Publication date | Patent family member(s) | | Publication date |
|---|---|---|---|---|---|
| EP 2219266 | A1 | 18-08-2010 | EP | 2219266 A1 | 18-08-2010 |
| | | | JP | 5222532 B2 | 26-06-2013 |
| | | | JP | 2009124437 A | 04-06-2009 |
| | | | US | 2010230596 A1 | 16-09-2010 |
| | | | WO | 2009063733 A1 | 22-05-2009 |
| US 2010026401 | A1 | 04-02-2010 | JP | 5366663 B2 | 11-12-2013 |
| | | | JP | 2010057161 A | 11-03-2010 |
| | | | US | 2010026401 A1 | 04-02-2010 |
| FR 2908931 | A1 | 23-05-2008 | EP | 2095467 A1 | 02-09-2009 |
| | | | FR | 2908931 A1 | 23-05-2008 |
| | | | JP | 5227327 B2 | 03-07-2013 |
| | | | JP | 2010510703 A | 02-04-2010 |
| | | | US | 2010033709 A1 | 11-02-2010 |
| | | | WO | 2008071863 A1 | 19-06-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010057161 A